# EUROPEAN PATENT APPLICATION

(11) **EP 4 575 711 A1**
(43) Date of publication of application: **25.06.2025**
(21) Application number: 23868437.7
(22) Date of filing: 01.09.2023
(51) Int. Cl.: G06F 1/16

(54) **ELECTRONIC DEVICE COMPRISING STRUCTURE FOR SUPPORTING DISPLAY**

(30) Priority: 21.09.2022 KR 20220119664; 12.10.2022 KR 20220130824
(71) Applicant: Samsung Electronics Co., Ltd., Suwon-si, Gyeonggi-do 16677 (KR)
(72) Inventor: WOO, Sunggwan, Suwon-si, Gyeonggi-do 16677 (KR); KIM, Jonghae, Suwon-si, Gyeonggi-do 16677 (KR); YANG, Byungduk, Suwon-si, Gyeonggi-do 16677 (KR)
(74) Representative: Gulde & Partner
(86) International application number: PCT/KR2023/013081
(87) International publication number: WO 2024/063382

(57) **Abstract**

An electronic device according to one embodiment comprises: a first cover; a second cover that can move with respect to the first cover; and a display including a first area and a second area extending from the first area, wherein: a first position having a minimum radius of curvature in the second area is located between a second position of the second area, in which the direction in which a virtual plane coming in contact with the second area bent to have a curvature in the first cover is oriented corresponds to the direction in which the first area is oriented, and a third position of the second area in which the direction in which the virtual plane is oriented is vertical to the direction in which the first area is oriented; and the direction in which the virtual plane coming in contact with the first position is oriented is slanted to be within a reference angular range with respect to the direction in which the first area is oriented.

## Description

### [Technical Field]

The present disclosure relates to an electronic device including a structure for supporting a display.

### [Background Art]

In order for a user to easily carry an electronic device, the electronic device may be miniaturized. Despite miniaturization of the electronic device, there is an increasing need for the electronic device in which a size of a display for displaying contents may be changed so that the user may be provided with various contents through the electronic device. For example, the electronic device may include a flexible display in which the size of the display exposed to an outside of the electronic device may be changed.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device according to an embodiment may comprise a first cover. According to an embodiment, the electronic device may comprise a second cover movable in a first direction or a second direction opposite to the first direction with respect to the first cover. According to an embodiment, the electronic device may comprise a display including a first region that is exposed to an outside of the first cover independently of movement of the second cover in the first direction and movement of the second cover in the second direction and a second region extending from the first region, wherein the second region is exposed to the outside of the first cover as the second cover moves in the first direction or is rolled into an inside of the first cover as the second cover moves in the second direction. According to an embodiment, a first position having a minimum radius of curvature in the second region may be located between a second position of the second region in which a direction toward which a virtual surface that contacts the second region bent to have curvature in the first cover faces corresponds to a direction toward which the first region faces and a third position of the second region in which the direction toward which the virtual surface faces is perpendicular to the direction toward which the first region faces. According to an embodiment, a direction toward which the virtual surface that contacts the first position faces may be inclined with respect to the direction toward which the first region faces, within a reference angle range.

An electronic device according to an embodiment may comprise a first cover. According to an embodiment, the electronic device may comprise a second cover, at least partially surrounded by the first cover, slidable with respect to the first cover in a first direction or a second direction opposite the first direction. According to an embodiment, the electronic device may comprise a display including a first region in contact with a surface of the second cover and a second region extending from the first region, wherein the second region is exposed to an outside of the second cover as the second cover moves in the first direction or covered by the first cover as the second cover moves in the second direction. According to an embodiment, a first position having a minimum radius of curvature in the second region may be located between a second position of the second region in which a direction toward which a virtual surface that contacts the second region bent to have curvature in the first cover faces corresponds to a direction toward which the first region faces and a third position of the second region in which a direction toward which the virtual surface faces is perpendicular to the direction toward which the first region faces. According to an embodiment, a direction toward which the virtual surface that contacts the first position faces may be inclined with respect to the direction toward which the first region faces within a reference angle range. According to an embodiment, the minimum radius of curvature may less than half a height of an inner lateral surface of the first cover perpendicular to a direction toward which the first region faces.

### [Description of the Drawings]

FIG. 1 is a block diagram of an electronic device within a network environment according to various embodiments.
FIG. 2A is a top plan view of an exemplary electronic device in a first state.
FIG. 2B is a bottom view of an exemplary electronic device in a first state.
FIG. 2C is a top plan view of an exemplary electronic device in a second state.
FIG. 2D is a bottom view of an exemplary electronic device in a second state.
FIGS. 3A and 3B are exploded perspective views of an exemplary electronic device.
FIG. 4A is a cross-sectional view of an exemplary electronic device in a first state.
FIG. 4B is a cross-sectional view of an exemplary electronic device in a second state.
FIG. 5A is a perspective view of an exemplary electronic device in a second state.
FIG. 5B is a cross-sectional view illustrating an example of an exemplary electronic device cut along line C-C' of FIG. 5A, according to an embodiment.
FIG. 6 is a cross-sectional view illustrating an example of cutting an exemplary electronic device according to an embodiment.
FIG. 7A is a cross-sectional view illustrating an example of cutting an exemplary electronic device according to an embodiment.
FIG. 7B is a cross-sectional view illustrating an example of cutting an exemplary electronic device according to an embodiment.
FIGS. 8A, 8B, 8C, and 8D are cross-sectional views illustrating an example of cutting an exemplary electronic device according to an embodiment.
FIGS. 9A, 9B, and 9C are cross-sectional views illustrating an example of cutting an exemplary electronic device according to an embodiment.
FIG. 10 is a cross-sectional view illustrating an example of cutting an exemplary electronic device according to an embodiment.

### [Mode for Invention]

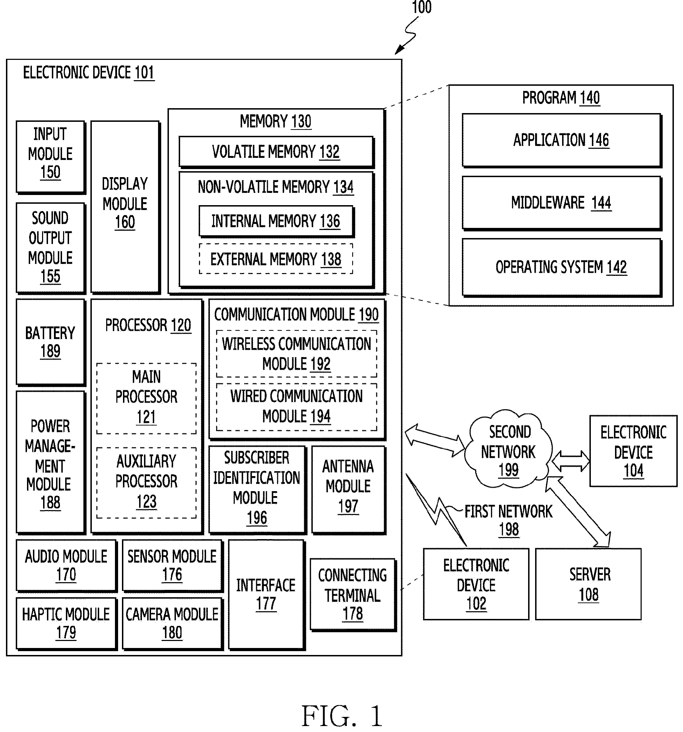

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semisupervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

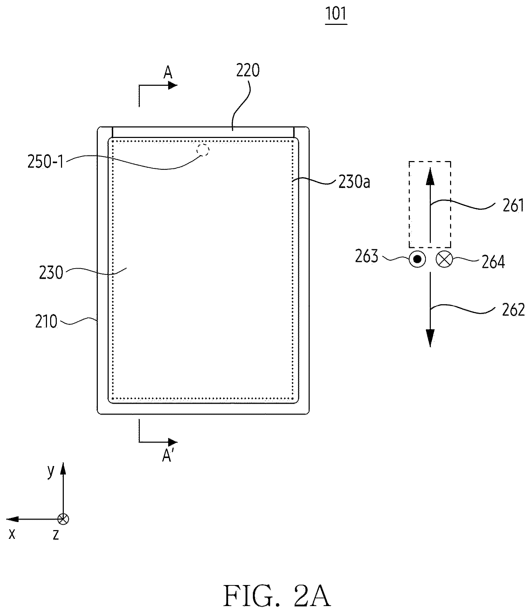

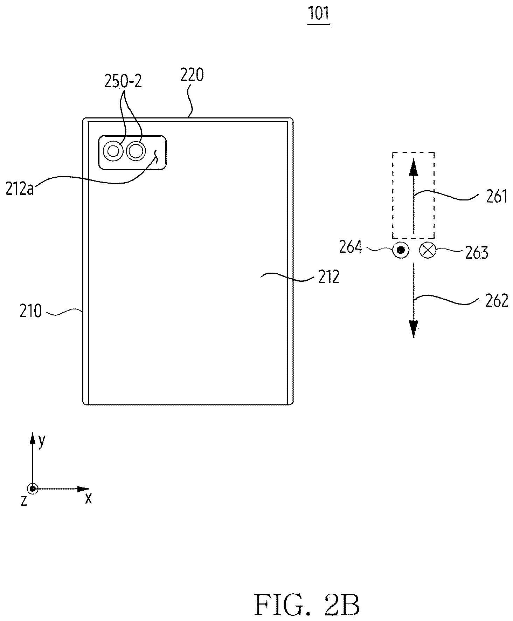

For example, a display of the display module 160 may be flexible. For example, the display may include a display region exposed outside a housing of the electronic device 101 that provides at least a portion of an outer surface of the electronic device 101. For example, since the display has flexibility, at least a portion of the display may be rolled into the housing or may be slidable into the housing. For example, a size of the display region may be changed according to a size of the at least a portion of the display rolled into the housing or slid into the housing. For example, the electronic device 101 including the display may be in a plurality of states including a first state providing the display region having a first size and a second state providing the display region having a second size different from the first size. For example, the first state may be exemplified through a description of FIGS. 2A and 2B.

FIG. 2A is a top plan view of an exemplary electronic device 101 in a first state.

Referring to FIG. 2A, the electronic device 101 may include a first housing 210, a second housing 220 that is movable with respect to the first housing 210 in a first direction 261 parallel to a y-axis, or a second direction 262 that is parallel to the y-axis and opposite to the first direction 261, and a display 230 (e.g., the display).

For example, the electronic device 101 may be in the first state. For example, in the first state, the second housing 220 may be movable with respect to the first housing 210 in the first direction 261 from among the first direction 261 and the second direction 262. For example, in the first state, the second housing 220 may not be movable in the second direction 262 with respect to the first housing 210.

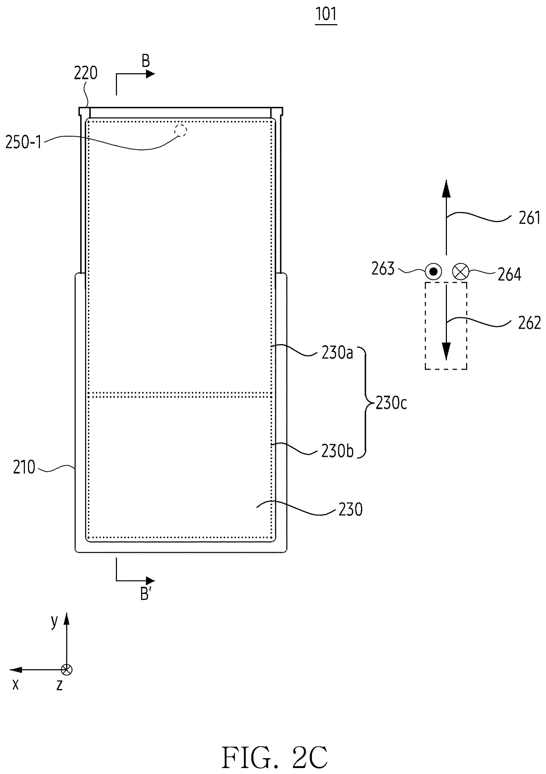

For example, in the first state, the display 230 may provide the display region having a smallest size. For example, in the first state, the display region may correspond to a region 230a. For example, although not illustrated in FIG. 2A, in the first state, a region (e.g., a region 230b of FIG. 2C) of the display 230, different from the region 230a which is the display region, may be at least partially included in the first housing 210. For example, in the first state, the region may be covered by the first housing 210. For example, in the first state, the region may be rolled into the first housing 210. For example, in the first state, the region 230a may include a planar portion, unlike the region including a curved portion. However, it is not limited thereto. For example, in the first state, the region 230a may include the curved portion extending from the planar portion and located within an edge portion.

For example, the first state may be referred to as a slide-in state or a closed state in terms of at least a portion of the second housing 220 being located in the first housing 210. For example, the first state may be referred to as a reduced state in terms of providing the display region having the smallest size. However, it is not limited thereto.

For example, the first housing 210 may include a first image sensor 250-1 in a camera module 180 that is exposed through a portion of the region 230a and faces a third direction 263 (e.g., a -z-axis direction) parallel to a z-axis. For example, although not illustrated in FIG. 2A, the second housing 220 may include one or more second image sensors in the camera module 180 that are exposed through a portion of the second housing 220 and face a fourth direction 264 parallel to the z-axis and opposite to the third direction 263. For example, the one or more second image sensors may be exemplified through a description of FIG. 2B.

FIG. 2B is a bottom view of an exemplary electronic device in a first state.

Referring to FIG. 2B, in the first state, one or more second image sensors 250-2 disposed in the second housing 220 may be located within a structure disposed in the first housing 210 for the one or more second image sensors 250-2. For example, in the first state, light from an outside of the electronic device 101 may be received by the one or more second image sensors 250-2 through the structure. For example, since the one or more second image sensors 250-2 are located within the structure in the first state, the one or more second image sensors 250-2 may be exposed through the structure in the first state. For example, the structure may be implemented in various ways. For example, the structure may be an opening or a notch. For example, the structure may be an opening 212a in a first plate 212 of the first housing 210 surrounding the at least a portion of the second housing 220. However, it is not limited thereto. For example, in the first state, the one or more second image sensors 250-2 included in the second housing 220 may be covered by the first plate 212 of the first housing 210.

Referring back to FIG. 1, the first state may be changed to the second state.

For example, the first state (or the second state) may be changed to the second state (or the first state) through one or more intermediate states between the first state and the second state.

For example, the first state (or the second state) may be changed to the second state (or the first state) based on a predefined user input. For example, the first state (or the second state) may be changed to the second state (or the first state) in response to the user input to a physical button exposed through a portion of the first housing 210 or the portion of the second housing 220. For example, the first state (or the second state) may be changed to the second state (or the first state) in response to a touch input to an executable object displayed in the display region. For example, the first state (or the second state) may be changed to the second state (or the first state) in response to a touch input having a contact point on the display region and a pressing strength of more than a reference strength. For example, the first state (or the second state) may be changed to the second state (or the first state) in response to a voice input received through a microphone of the electronic device 101. For example, the first state (or the second state) may be changed to the second state (or the first state) in response to an external force applied to the first housing 210 and/or the second housing 220 for moving the second housing 220 with respect to the first housing 210. For example, the first state (or the second state) may be changed to the second state (or the first state) in response to a user input identified on an external electronic device (e.g., earbuds or a smart watch) connected to the electronic device 101. However, it is not limited thereto.

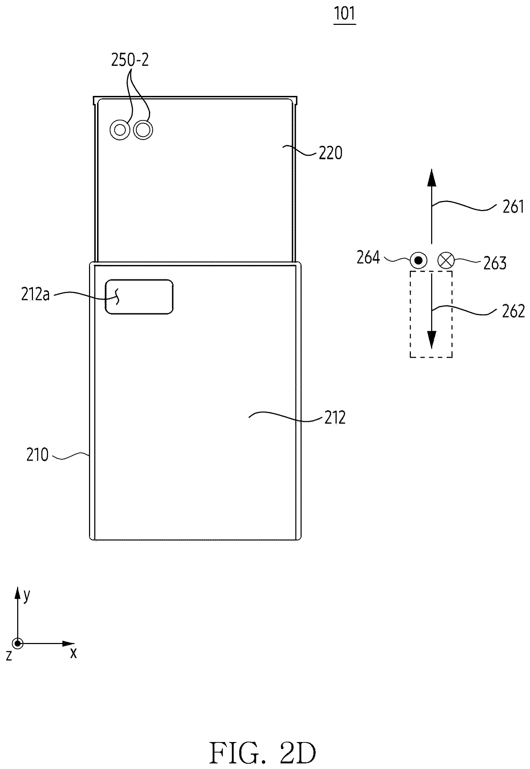

The second state may be exemplified through a description of FIGS. 2C and 2D.

FIG. 2C is a top plan view of an exemplary electronic device in a second state.

Referring to FIG. 2C, the electronic device 101 may be in the second state. For example, in the second state, the second housing 220 may be movable with respect to the first housing 210 in the second direction 262 from among the first direction 261 and the second direction 262. For example, in the second state, the second housing 220 may not be movable in the first direction 261 with respect to the first housing 210.

For example, in the second state, the display 230 may provide the display region having a largest size. For example, in the second state, the display region may correspond to a region 230c including the region 230a and a region 230b. For example, the region 230b that was included in the first housing 210 in the first state may be at least partially exposed in the second state. For example, in the second state, the region 230a may include the planar portion. However, it is not limited thereto. For example, the region 230a may include the curved portion extending from the planar portion and located within the edge portion. For example, in the second state, the region 230b, unlike the region 230a in the first state, may include the planar portion from among the planar portion and the curved portion. However, it is not limited thereto. For example, the region 230b may include the curved portion extending from the planar portion of the region 230b and located within the edge portion.

For example, the second state may be referred to as a slide-out state or an open state in terms of the at least a portion of the second housing 220 being located outside the first housing 210. For example, the second state may be referred to as an extended state in terms of providing the display region having the largest size. However, it is not limited thereto.

For example, when a state of the electronic device 101 changes from the first state to the second state, the first image sensor 250-1 facing the third direction 263 may be moved together with the region 230a according to movement of the second housing 220 in the first direction 261. For example, although not illustrated in FIG. 2C, when the state of the electronic device 101 changes from the first state to the second state, one or more second image sensors 250-2 facing the fourth direction 264, may be moved according to the movement of the second housing 220 in the first direction 261. For example, a relative positional relationship between the one or more second image sensors 250-2 and the structure exemplified through the description of FIG. 2B may be changed according to the movement of the one or more second image sensors 250-2. For example, the change in the relative positional relationship may be exemplified through FIG. 2D.

FIG. 2D is a bottom view of an exemplary electronic device 101 in a second state.

Referring to FIG. 2D, in the second state, one or more second image sensors 250-2 may be located outside the structure. For example, in the second state, the one or more second image sensors 250-2 may be located outside the opening 212a in the first plate 212. For example, since the one or more second image sensors 250-2 are located outside the opening 212a in the second state, the one or more second image sensors 250-2 may be exposed in the second state. For example, since the one or more second image sensors 250-2 are located outside the structure in the second state, the relative positional relationship in the second state may be different from the relative positional relationship in the first state.

For example, in case that the electronic device 101 does not include the structure, such as the opening 212a, the one or more second image sensors 250-2 in the second state may be exposed, unlike the one or more second image sensors 250-2 in the first state.

Although not illustrated in FIGS. 2A, 2B, 2C, and 2D, the electronic device 101 may be in an intermediate state between the first state and the second state. For example, a size of the display region in the intermediate state may be larger than a size of the display region in the first state and smaller than a size of the display region in the second state. For example, the display region in the intermediate state may correspond to a region including the region 230a and a portion of the region 230b. For example, in the intermediate state, a portion of the region 230b may be exposed, and another portion (or a remaining portion) of the region 230b may be covered by the first housing 210 or rolled into the first housing 210. However, it is not limited thereto.

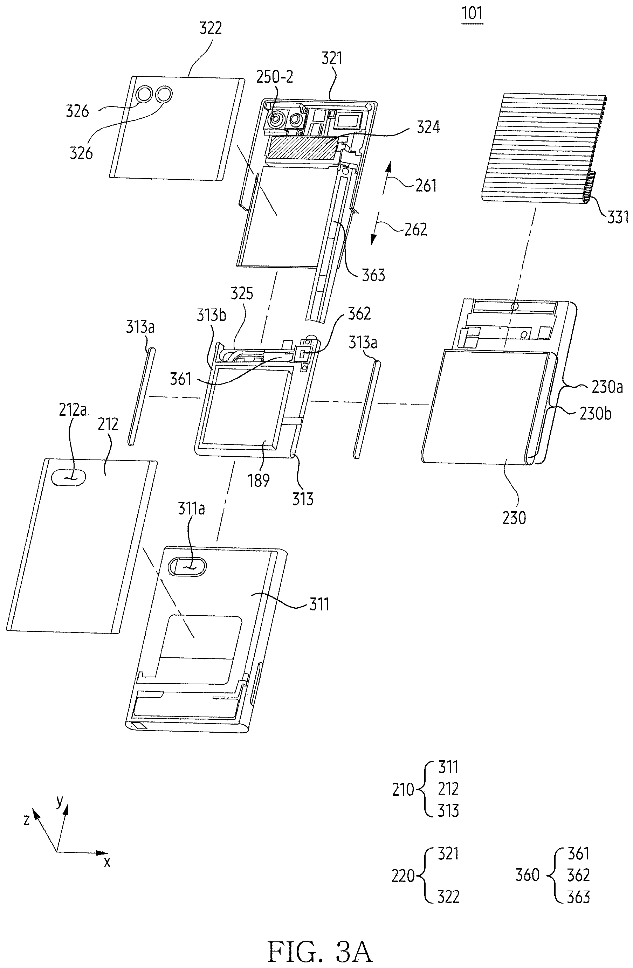

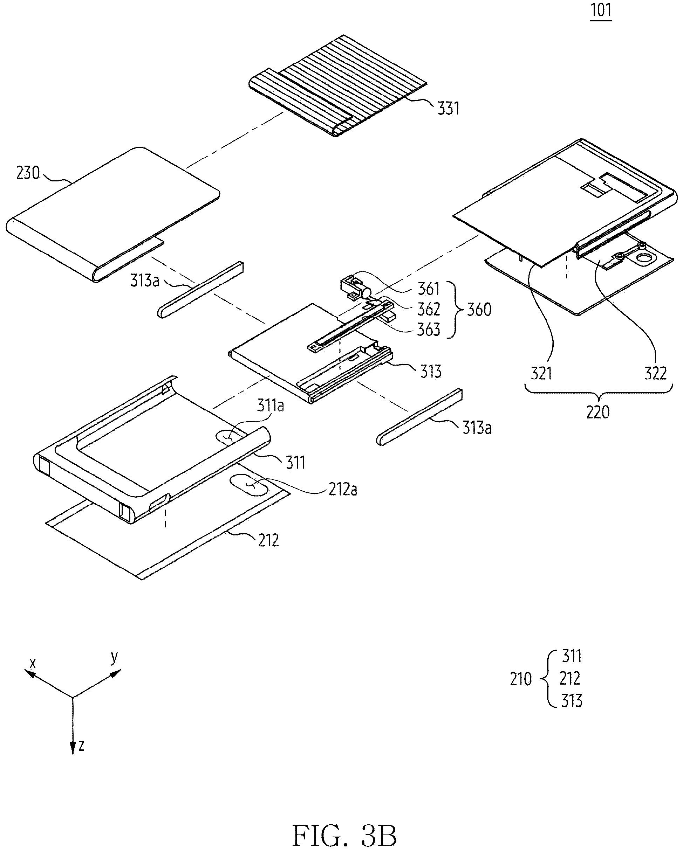

The electronic device 101 may include structures for moving the second housing (e.g., the second housing 220 of FIGS. 2A to 2D) of the electronic device 101 with respect to the first housing (e.g., the first housing 210 of FIGS. 2A to 2D) of the electronic device 101. For example, the structures may be exemplified through a description of FIGS. 3A and 3B.

FIGS. 3A and 3B are exploded perspective views of an exemplary electronic device.

Referring to FIGS. 3A and 3B, an electronic device 101 may include a first housing 210, a second housing 220, a display 230, and a driving portion 360.

For example, the first housing 210 may include a first cover 311, a first plate 212, and a frame 313.

For example, the first cover 311 may at least partially form a lateral surface portion of an outer surface of the electronic device 101. For example, the first cover 311 may at least partially form a rear surface portion of the outer surface. For example, the first cover 311 may include an opening 311a for one or more second image sensors 250-2. For example, the first cover 311 may include a surface supporting the first plate 212. For example, the first cover 311 may be coupled to the first plate 212. For example, the first cover 311 may include the frame 313. For example, the first cover 311 may be coupled to the frame 313.

For example, the first plate 212 may at least partially form a rear portion of the outer surface. For example, the first plate 212 may include an opening 212a for the one or more second image sensors 250-2. For example, the first plate 212 may be disposed on the surface of the first cover 311. For example, the opening 212a may be aligned with the opening 311a.

For example, the frame 313 may be at least partially surrounded by the first cover 311.

For example, the frame 313 may be at least partially surrounded by the display 230. For example, the frame 313 may be at least partially surrounded by the display 230, but a position of the frame 313 may be maintained independently of movement of the display 230. For example, the frame 313 may be arranged in relation to at least a portion of components of the display 230. For example, the frame 313 may include rails 313a that provide (or guide) a path of movement of at least one component of the display 230.

For example, the frame 313 may be coupled to at least one component of the electronic device 101. For example, the frame 313 may support a rechargeable battery 189. For example, the battery 189 may be supported through a recess or hole in a surface 313b of the frame 313. For example, the frame 313 may be coupled to an end of a flexible printed circuit board (FPCB) 325 on a surface of the frame 313. For example, although not explicitly illustrated in FIGS. 3A and 3B, another end of the FPCB 325 may be connected to a PCB 324 through at least one connector. For example, the PCB 324 may be electrically connected to another PCB (not illustrated in FIGS. 3A and 3B) that supplies power to a motor 361 through the FPCB 325.

For example, the frame 313 may be coupled to at least one structure of the electronic device 101 for a plurality of states including the first state and the second state. For example, the frame 313 may fasten the motor 361 of the driving portion 360.

For example, the second housing 220 may include a second cover 321 and a second plate 322.

For example, the second cover 321 may be at least partially surrounded by the display 230. For example, the second cover 321 may be coupled to at least a portion of a region 230a of the display 230 surrounding the second cover 321, unlike the frame 313, such that the display 230 moves along the second housing 220 that is moved with respect to the first housing 210.

For example, the second cover 321 may be coupled to the at least one component of the electronic device 101. For example, the second cover 321 may be coupled to the printed circuit board (PCB) 324 including components of the electronic device 101. For example, the PCB 324 may include a processor (e.g., the processor 120 of FIG. 1) (not illustrated in FIGS. 3A and 3B). For example, the second cover 321 may include the one or more second image sensors 250-2.

For example, the second cover 321 may be coupled to at least one structure of the electronic device 101 for the plurality of states including the first state and the second state. For example, the second cover 321 may fasten a rack gear 363 of the driving portion 360.

For example, the second cover 321 may be coupled to the second plate 322.

For example, the second plate 322 may be coupled to the second cover 321 to protect at least one component of the electronic device 101 coupled in the second cover 321 and/or at least one structure of the electronic device 101 coupled in the second cover 321. For example, the second plate 322 may include a structure for the at least one component. For example, the second plate 322 may include one or more openings 326 for the one or more second image sensors 250-2. For example, the one or more openings 326 may be aligned with the one or more second image sensors 250-2 disposed on the second cover 321. For example, a size of each of one or more openings 326 may correspond to a size of each of the one or more second image sensors 250-2.

For example, the display 230 may include a supporting member 331. For example, the supporting member 331 may include a plurality of bars. For example, the plurality of bars may be coupled to each other. The supporting member 331 may support a region 230b of the display 230.

For example, the driving portion 360 may include the motor 361, a pinion gear 362, and the rack gear 363.

For example, the motor 361 may operate based on power from the battery 189. For example, the power may be provided to the motor 361 in response to the predefined user input.

For example, the pinion gear 362 may be coupled to the motor 361 through a shaft. For example, the pinion gear 362 may be rotated based on the operation of the motor 361 transmitted through the shaft.

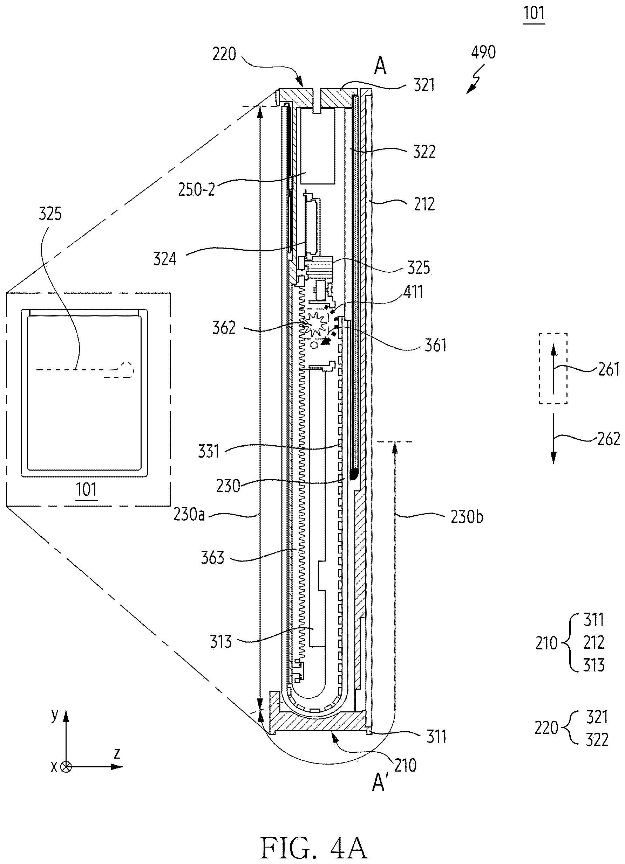

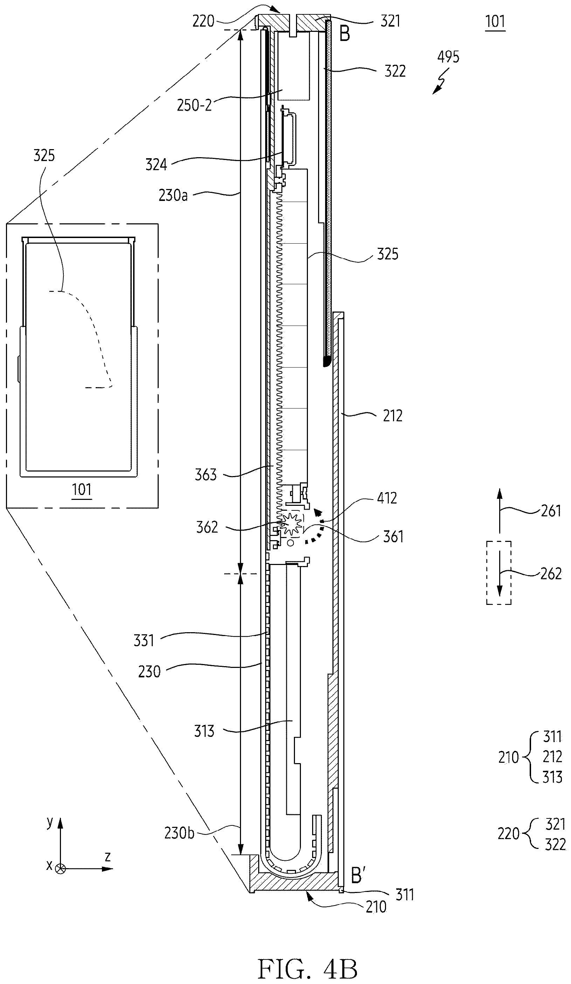

For example, the rack gear 363 may be arranged in association with the pinion gear 362. For example, teeth of the rack gear 363 may be engaged with teeth of the pinion gear 362. For example, the rack gear 363 may be moved in a first direction 261 or a second direction 262 according to rotation of the pinion gear 362. For example, the second housing 220 may be moved in the first direction 261 and the second direction 262 by the rack gear 363 that is moved according to the rotation of the pinion gear 362 due to the operation of the motor 361. For example, the first state of the electronic device 101 may be changed to a state (e.g., the one or more intermediate states or the second state) different from the first state through the movement of the second housing 220 in the first direction 261. For example, the second state of the electronic device 101 may be changed to a state (e.g., the one or more intermediate states or the first state) different from the second state through the movement of the second housing 220 in the second direction 262. For example, the first state being changed to the second state by the driving portion 360, and the second state being changed to the first state by the driving portion 360, may be exemplified through FIGS. 4A and 4B.

FIG. 4A is a cross-sectional view of an exemplary electronic device in a first state. FIG. 4B is a cross-sectional view of an exemplary electronic device in a second state.

Referring to FIGS. 4A and 4B, a motor 361 may be operated based at least in part on the predefined user input received in a state 490 that is the first state. For example, a pinion gear 362 may be rotated in a first rotation direction 411 at least partially based on the operation of the motor 361. For example, a rack gear 363 may be moved in a first direction 261 at least partially based on the rotation of the pinion gear 362 in the first rotation direction 411. For example, since a second cover 321 in a second housing 220 fastens the rack gear 363, the second housing 220 may be moved in the first direction 261 at least partially based on the movement of the rack gear 363 in the first direction 261. For example, since the second cover 321 in the second housing 220 is coupled to at least a portion of a region 230a of a display 230 and fastens the rack gear 363, the display 230 may be moved at least partially based on the movement of the rack gear 363 in the first direction 261. For example, the display 230 may be moved along rails (e.g., the rails 313a of FIGS. 3A and 3B). For example, a shape of at least a portion of the plurality of bars of a supporting member 331 of the display 230 may be changed when the state 490 changes to a state 495 that is the second state.

For example, a region 230b of the display 230 may be moved according to the movement of the display 230. For example, when the state 490 changes to the state 495 according to the predefined user input, the region 230b may be moved through a space between a first cover 311 and a frame 313. For example, the region 230b in the state 495 may be exposed, unlike the region 230b rolled into the space in the state 490.

For example, since the second cover 321 in the second housing 220 is coupled to a PCB 324 connected to the other end of an FPCB 325 and fastens the rack gear 363, a shape of the FPCB 325 may be changed when the state 490 changes to the state 495.

The motor 361 may be operated at least partially based on the predefined user input received in the state 495. For example, the pinion gear 362 may be rotated in a second rotation direction 412 the at least partially based on the operation of the motor 361. For example, the rack gear 363 may be moved in a second direction 262 at least partially based on the rotation of the pinion gear 362 in the second rotation direction 412. For example, since the second cover 321 within the second housing 220 fastens the rack gear 363, the second housing 220 may be moved in the second direction 262 at least partially based on the movement of the rack gear 363 in the second direction 262. For example, since the second cover 321 in the second housing 220 is coupled to at least a portion of the region 230a of the display 230 and fastens the rack gear 363, the display 230 may be moved at least partially based on the movement of the rack gear 363 in the second direction 262. For example, the display 230 may be moved along the rails 313a. For example, a shape of the at least a portion of the plurality of bars of the supporting member 331 of the display 230 may be changed when the state 495 changes to the state 490. The supporting member 331 may be moved with respect to a first housing 210. The supporting member 331 accommodated inside the first housing 210 in the state 490 may be located between the first cover 311 and the frame 313. According to movement of the supporting member 331, the display 230 may be moved with respect to the first housing 210.

For example, the region 230b of the display 230 may be moved according to the movement of the display 230. For example, the region 230b may be moved through the space between the first cover 311 and the frame 313 when the state 495 changes to the state 490 according to the predefined user input. For example, the region 230b in the state 490 may be rolled into the space, unlike the region 230b exposed in the state 495.

For example, since the second cover 321 in the second housing 220 is coupled to the PCB 324 connected to the other end of the FPCB 325 and fastens the rack gear 363, the shape of the FPCB 325 may be changed when the state 495 changes to the state 490.

FIGS. 2A to 4B illustrate the electronic device 101 in which a height of the display region is changed and width of the display region is maintained when the first state (or the second state) is changed to the second state (or the first state) in a portrait mode, but it is for convenience of explanation. For example, when the first state (or the second state) changes to the second state (or the first state) in the portrait mode, the electronic device 101 may be implemented such that the height of the display region is maintained and the width of the display region is changed.

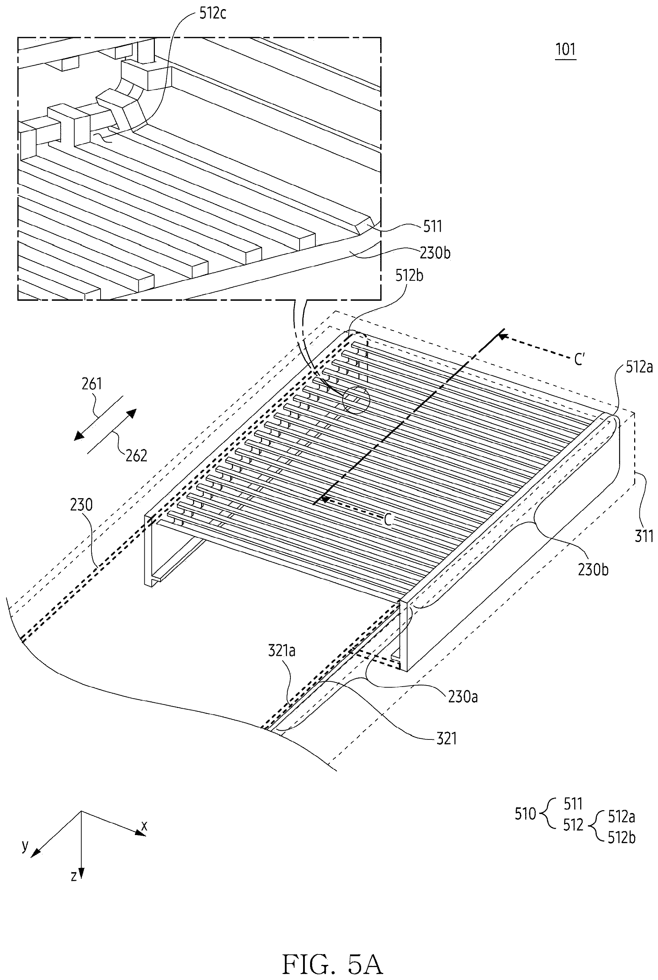

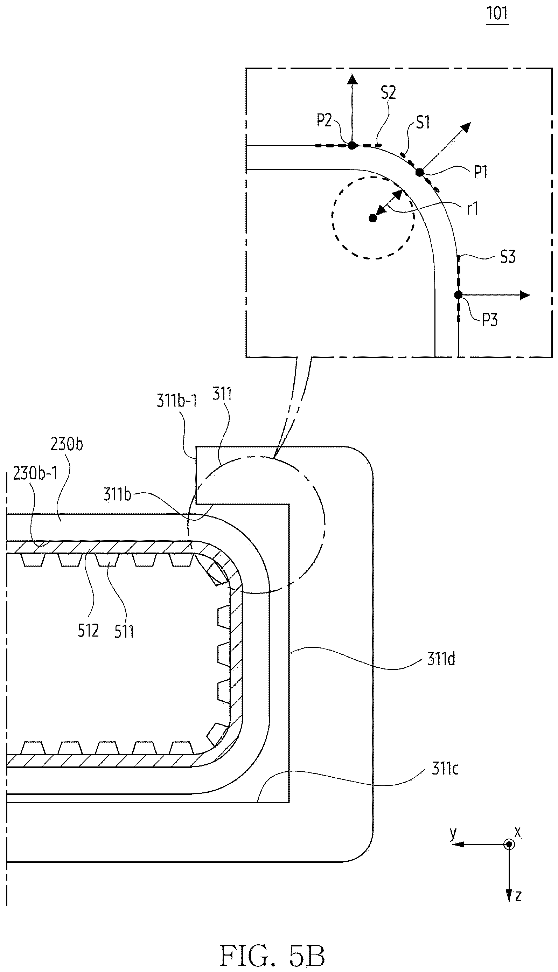

FIG. 5A is a perspective view of an exemplary electronic device in a second state and FIG. 5B is a cross-sectional view illustrating an example of an exemplary electronic device cut along line C-C' of FIG. 5A, according to an embodiment.

Referring to FIGS. 5A and 5B, an electronic device 101 according to an embodiment may include a first cover 311, a second cover 321, a display 230, and/or a guide member 510.

According to an embodiment, the first cover 311 may define at least a portion of an outer surface of the electronic device 101. The first cover 311 may define a space in which components of the electronic device 101 are disposed. For example, the second cover 321 may be movable in the first cover 311. For example, the display 230 may be movable in the first cover 311.

According to an embodiment, the second cover 321 may be movable with respect to the first cover 311. For example, the second cover 321 may be movable in a first direction 261 (e.g., a +y direction) or a second direction 262 (e.g., a -y direction) opposite to the first direction 261 with respect to the first cover 311. According to an embodiment, the second cover 321 may be slidable with respect to the first cover 311. For example, the second cover 321 may be slidable outside the first cover 311 as the second cover 321 moves in the first direction 261 with respect to the first cover 311. For example, the second cover 321 may be slidable inside the first cover 311 as the second cover 321 moves in the second direction 262 with respect to the first cover 311. According to an embodiment, the second cover 321 may support the display 230. For example, the display 230 may be disposed on a surface 321a of the second cover 321. For example, the display 230 may be attached to the surface 321a of the second cover 321.

According to an embodiment, the display 230 may be configured to provide visual information. For example, the display 230 may emit light to provide the visual information to a user along a direction toward which the surface 321a of the second cover 321 faces. As the display 230 is coupled to the second cover 321, the display 230 may move with respect to the first cover 311 by movement of the second cover 321. For example, as the second cover 321 moves in the first direction 261, the display 230 may move outside the first cover 311 together with the second cover 321. For example, as the second cover 321 moves in the second direction 262, the display 230 may move inside the first cover 311 together with the second cover 321. According to an embodiment, the display 230 may include a first region 230a and a second region 230b.

According to an embodiment, the first region 230a may be disposed on the surface 321a of the second cover 321. A direction (e.g., a -z direction) toward which the first region 230a faces may be substantially the same as a direction toward which light is emitted from at least a portion of the display 230 exposed to the outside of the electronic device 101. For example, the direction toward which the first region 230a faces may be substantially the same as the direction toward which the surface 321a of the second cover 321 faces. According to an embodiment, the first region 230a may be exposed to the outside of the first cover 311 in a first state (e.g., a slide-in state and/or a reduced state) and a second state (e.g., a slide-out state and/or an extended state) of the electronic device 101. For example, the first region 230a may be exposed to the outside of the first cover 311 independently of movement of the second cover 321 in the first direction 261 and movement of the second cover 321 in the second direction 262. According to an embodiment, a shape of the first region 230a may be maintained while a state of the electronic device 101 is changed. For example, the shape of the first region 230a may maintain a shape substantially parallel to the surface 321a of the second cover 321 in the first state and the second state of the electronic device 101.

According to an embodiment, the second region 230b may be connected to the first region 230a. For example, the second region 230b may extend from the first region 230a. According to an embodiment, the second region 230b may be spaced apart from the surface 321a of the second cover 321. Since the second region 230b is connected to the first region 230a disposed on the second cover 321, the second region 230b may move together with the second cover 321 as the second cover 321 moves. According to an embodiment, a shape of the second region 230b may be deformable as the second cover 321 moves with respect to the first cover 311. For example, at least a portion of the second region 230b may be exposed to the outside of the first cover 311 as the second cover 321 moves in the first direction 261. The at least a portion of the second region 230b exposed to the outside of the first cover 311 may have a shape substantially parallel to the first region 230a. For example, at least a portion of the second region 230b may be rolled into the inside of the first cover 311 as the second cover 321 moves in the second direction 262. The at least a portion of the second region 230b rolled in the first cover 311 may be bent to have curvature in the first cover 311. According to an embodiment, as the second cover 321 moves, a size of the second region 230b exposed to the outside of the first cover 311 may be changed. For example, at least a portion of the second region 230b may be exposed to the outside of the first cover 311 according to the movement of the second cover 321 in the first direction 261. For example, at least a portion of the second region 230b may be exposed to the outside of the first cover 311 in the second state of the electronic device 101. For example, at least a portion of the second region 230b may be rolled into the first cover 311 as the second cover 321 moves in the second direction 262. For example, at least a portion of the second region 230b may be covered by the first cover 311 according to the movement of the second cover 321 in the second direction 262. For example, at least a portion of the second region 230b may not be visually exposed to the outside of the first cover 311 in the first state of the electronic device 101.

According to an embodiment, the first cover 311 may include a first inner surface 311b, a second inner surface 311c, and/or an inner lateral surface 311d. The first inner surface 311b may face a direction (e.g., a +z direction) opposite to the direction (e.g., the -z direction) toward which the first region 230a faces. According to an embodiment, the first inner surface 311b may face the display 230 inside the first cover 311. For example, the first inner surface 311b may face the second region 230b. The first inner surface 311b may be substantially parallel to the first region 230a of the display 230. According to an embodiment, the first inner surface 311b may cover a portion of the display 230. For example, the first inner surface 311b may be superimposed on the portion of the display 230 when the first cover 311 is viewed from above (e.g., the -z direction). According to an embodiment, an end 311b-1 of the first inner surface 311b may be disposed on a boundary between the first region 230a and the second region 230b in the first state of the electronic device 101. For example, the end 311b-1 of the first inner surface 311b may be superimposed on the boundary between the first region 230a and the second region 230b when the display 230 is viewed from above (e.g., the -z direction) in the first state of the electronic device 101.

The second inner surface 311c may face a direction corresponding to the direction (e.g., the -z direction) toward which the first region 230a faces. According to an embodiment, the second inner surface 311c may face the display 230. For example, the second inner surface 311c may face the second region 230b and the first inner surface 311b. According to an embodiment, the second inner surface 311c may be spaced apart from the first inner surface 311b. For example, the second inner surface 311c may be spaced apart from the first inner surface 311b along a direction (e.g., the +z direction) toward which the first inner surface 311b faces.

The inner lateral surface 311d may connect the first inner surface 311b and the second inner surface 311c. For example, the inner lateral surface 311d may extend between the first inner surface 311b and the second inner surface 311b.

According to an embodiment, the second region 230b may be bent from a position corresponding to the end 311b-1 of the first inner surface 311b. For example, the end 311b-1 of the first inner surface 311b may be disposed on a boundary of a portion of the display 230 parallel to the surface 321a of the second cover 321 and another portion of the display 230 bent to have curvature. The end 311b-1 of the first inner surface 311b may be disposed on a boundary of a portion of the display 230 having no curvature and the other portion of the display 230 bent to have the curvature. According to an embodiment, curvature of the second region 230b may be changed. The curvature of the second region 230b may be changed in the first cover 311. For example, the second region 230b may not be circular in the first cover 311. As the curvature of the second region 230b changes, a radius of curvature of the second region 230b may be changed. The radius of curvature may mean a radius of a virtual circle in contact with a point in the second region 230b. According to an embodiment, a minimum radius of curvature r1 in the second region 230b may be smaller than half of a height of the inner lateral surface 311d of the first cover 311. The minimum radius of curvature r1 may mean a radius of a virtual circle having the smallest size among radii of virtual circles in contact with each position in the second region 230b. A height of a component may mean a distance in the direction (e.g., the -z direction) toward which the first region 230a faces. For example, in case that the minimum radius of curvature r1 in the second region 230b is more than half of the height of the inner lateral surface 311d of the first cover 311, since the second region 230b is bent to be close to the inner lateral surface 311d of the first cover 311, in order to secure a distance between the second region 230b and the inner lateral surface 311d of the first cover 311, width of the first inner surface 311b may be increased compared to a case where the minimum radius of curvature r1 in the second region 230b is smaller than half of the height of the inner lateral surface 311d of the first cover 311. The width of the component may mean a distance parallel to the first direction 261 or the second direction 262. When the width of the first inner surface 311b is increased, an area of the display 230 visible from the outside of the electronic device 101 may be reduced. Since the minimum radius of curvature r1 in the second region 230b is smaller than half of the height of the inner lateral surface 311d of the first cover 311, the electronic device 101 according to an embodiment may provide a structure with an expanded area of the display 230 visible from the outside.

According to an embodiment, a first position p1 having the minimum radius of curvature r1 in the second region 230b may be located between a second position p2 of the second region 230b in which a direction toward which a virtual surface s2 that contacts the second region 230b bent to have curvature in the first cover 311 faces is parallel to the direction toward which the first region 230a faces and a third position p3 of the second region 230b in which a direction toward which a virtual surface s3 faces is perpendicular to the direction toward which the first region 230a faces. The direction toward which the virtual surfaces s1, s2, and s3 faces may be substantially the same as a direction of a normal line of each point of the second region 230b. The normal line may be perpendicular to a tangential line or a tangent plane contacting each point of the second region 230b. For example, a direction (e.g., the -z direction) toward which the virtual surface s2 in contact with the second position p2 of the second region 230b faces may correspond to the direction (e.g., the -z direction) toward which the first region 230a faces. For example, the direction (e.g., the -z direction) toward which the virtual surface s2 in contact with the second position p2 of the second region 230b faces may be the same as the direction (e.g., the -z direction) toward which the first region 230a faces. For example, a direction (e.g., the -y direction) toward which the virtual surface s3 in contact with the third position p3 of the second region 230b faces may be substantially perpendicular to the direction (e.g., the -z direction) toward which the first region 230a faces. According to an embodiment, the first position p1 may mean a position on an outer surface of the second region 230b facing the first cover 311, but it is not limited thereto. For example, the first position p1 may mean a position on an inner surface of the second region 230b facing a guide rail 512. According to an embodiment, the first position p1 may have a point form, but it is not limited thereto. For example, the first position p1 may be defined in a line form.

According to an embodiment, the first position p1 may be spaced apart from the second position p2 and the third position p3. For example, the first position p1 may not coincide with the second position p2 and the third position p3, respectively, and may be distinguished. According to an embodiment, a direction toward which the virtual surface s1 in contact with the first position p1 faces may be inclined with respect to the direction (e.g., the -z direction) toward which the first region 230a faces. Being inclined with respect to a direction may mean a state that is parallel to the direction or not perpendicular to the direction. For example, the direction toward which the virtual surface s1 in contact with the first position p1 faces may be inclined in the direction toward which the first region 230a faces and the direction toward which the virtual surface s3 in contact with the third position p3 faces. According to an embodiment, the direction toward which the virtual surface s1 in contact with the first position p1 faces may be inclined within a reference angle range with respect to the direction (e.g., a -z direction) toward which the first region 230a faces. For example, an angle between the direction toward which the virtual surface s1 in contact with the first position p1 faces and the direction toward which the first region 230a faces may be about 30 degrees to about 60 degrees. For example, the angle between the direction toward which the virtual surface s1 in contact with the first position p1 faces and the direction toward which the first region 230a faces may be about 45 degrees. For example, in case that the first position p1 having the minimum radius of curvature r1 in the second region 230b is the same as the second position p2, the second region 230b may not have curvature. For example, in case that the first position p1 having the minimum radius of curvature r1 in the second region 230b is the same as the third position p3, the second region 230b may have an elliptical shape. In case that the second region 230b has the elliptical shape, since the second region 230b is bent to be close to the inner lateral surface 311d of the first cover 311, in order to secure a distance between the second region 230b and the inner lateral surface 311d of the first cover 311, the width of the first inner surface 311b may be increased compared to the case that the first position p1 and the third position p3 are distinguished. When the width of the first inner surface 311b is increased, the area of the display 230 visible from the outside of the electronic device 101 may be reduced. Since the first position p1 in the second region 230b having the minimum radius of curvature r1 is distinguished from the third position p3, the electronic device 101 according to an embodiment may provide the structure with the expanded area of the display 230 visible from the outside.

The guide member 510 may guide movement of the display 230. For example, the guide member 510 may guide the movement of the second region 230b of the display 230. According to an embodiment, the guide member 510 may include at least one guide bar 511 and at least one guide rail 512 (e.g., the rails 313a of FIGS. 3A and 3B).

The at least one guide bar 511 may support the second region 230b. According to an embodiment, the at least one guide bar 511 may be disposed on the second region 230b among the first region 230a and the second region 230b. For example, a plurality of guide bars may be disposed on an inner surface 230b-1 of the second region 230b. According to an embodiment, the at least one guide bar 511 may include the plurality of guide bars spaced apart from each other. For example, the plurality of guide bars may be spaced apart from each other along a moving direction of the display 230. According to an embodiment, as a shape of the display 230 is changed, the at least one guide bar 511 may have a shape corresponding to the shape of the display 230. For example, in case that the at least one guide bar 511 includes the plurality of guide bars, the plurality of guide bars may be arranged to have the shape corresponding to the shape of the display 230.

The at least one guide rail 512 may guide movement of the at least one guide bar 511. According to an embodiment, the at least one guide rail 512 may include a plurality of guide rails 512a and 512b spaced apart from each other. The plurality of guide rails 512a and 512b may surround the display 230. For example, the second region 230b may be movable between the plurality of guide rails 512a and 512b. According to an embodiment, the at least one guide rail 512 may include a guiding groove 512c. The guiding groove 512c may define a movement path of the at least one guide bar 511. For example, the guiding groove 512c may be formed by recessing the at least one guide rail 512 inward. According to an embodiment, the guiding groove 512c may surround the at least one guide bar 511. The at least one guide bar 511 may be accommodated in the guiding groove 512c. According to an embodiment, the guiding groove 512c may extend along the guide rail 512. As the guiding groove 512c defines the movement path of the at least one guide bar 511 guiding the movement of the display 230, a shape of the guiding groove 512c may define curvature of the display 230. For example, the guiding groove 512c may extend along the guide rail 512 such that the first position p1 is located on a corner of the guide rail 512. The corner of the guide rail 512 may mean an area of the guide rail 512 in contact with a portion of the guide rail 512 substantially parallel to the first inner surface 311b and another portion of the guide rail 512 substantially parallel to the inner lateral surface 311d.

As described above, since the second region 230b of the display 230 has changing curvature, the electronic device 101 according to an embodiment may provide a structure in which the area of the display 230 that is visible from the outside of the electronic device 101 is maximized. Since the first position p1 having a minimum radius of curvature in the second region 230b is spaced apart from the second position p2 and the third position p3, the electronic device 101 according to an embodiment may provide the structure in which the area of the display 230 that is visible from the outside of the electronic device 101 is maximized.

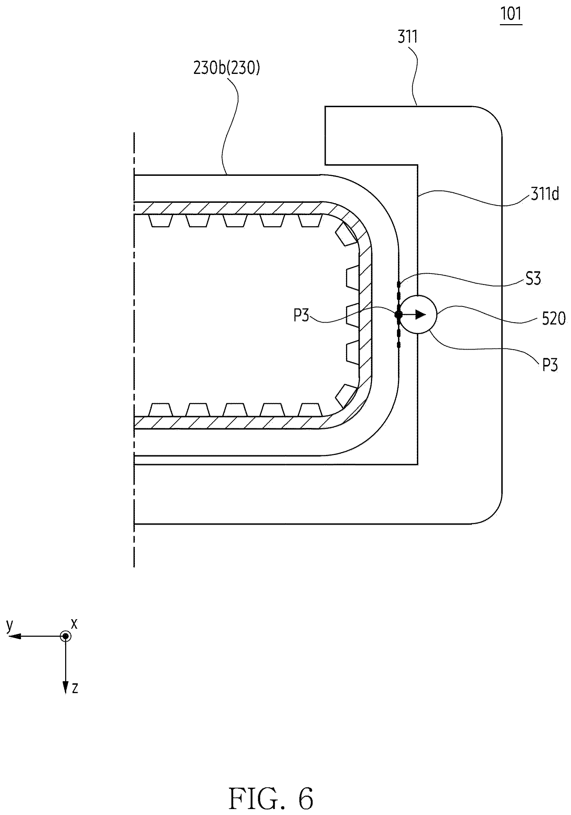

FIG. 6 is a cross-sectional view illustrating an example of cutting an exemplary electronic device according to an embodiment.

Referring to FIG. 6, according to an embodiment, a first cover 311 may include a first supporting member 520. The first supporting member 520 may support a second region 230b. For example, the first supporting member 520 may separate the second region 230b from an inner lateral surface 311d of the first cover 311. According to an embodiment, the first supporting member 520 may be disposed in the first cover 311. For example, the first supporting member 520 may be disposed on the inner lateral surface 311d in the first cover 311. According to an embodiment, the first supporting member 520 may be rotatable. For example, the first supporting member 520 may be rotatable with respect to the second region 230b. For example, the first supporting member 520 may be rotatable with respect to the inner lateral surface 311d of the first cover 311. However, it is not limited thereto, and the first supporting member 520 may be fastened to the inner lateral surface 311d of the first cover 311. In case that the first supporting member 520 is fastened to the inner lateral surface 311d, the first supporting member 520 may have a shape of a protrusion. For example, the first supporting member 520 may protrude from the inner lateral surface 311d.

According to an embodiment, a position of the first supporting member 520 may correspond to a third position p3 of the second region 230b in which a direction toward which a virtual surface s3 in contact with the second region 230b faces is perpendicular to a direction (e.g., the -z direction) toward which a first region (e.g., the first region 230a of FIG. 5A) faces. For example, the first supporting member 520 may be in contact with the third position p3 of the second region 230b. For example, in case that the first supporting member 520 is not disposed, the second region 230b may contact the inner lateral surface 311d as the second region 230b bends in a direction of approaching the inner lateral surface 311d of the first cover 311 due to repulsive force generated by bending of a display 230. In case that the second region 230b contacts the inner lateral surface 311d, the second region 230b may be damaged by contact with the inner lateral surface 311d. An electronic device 101 according to an embodiment may provide a structure capable of reducing damage to the display 230 by the first supporting member 520 in contact with the third position p3 of the second region 230b.

As described above, the electronic device 101 according to an embodiment may provide a structure capable of reducing contact between the second region 230b and the inner lateral surface 311d of the first cover 311 by the first supporting member 520 supporting the third position p3 of the second region 230b.

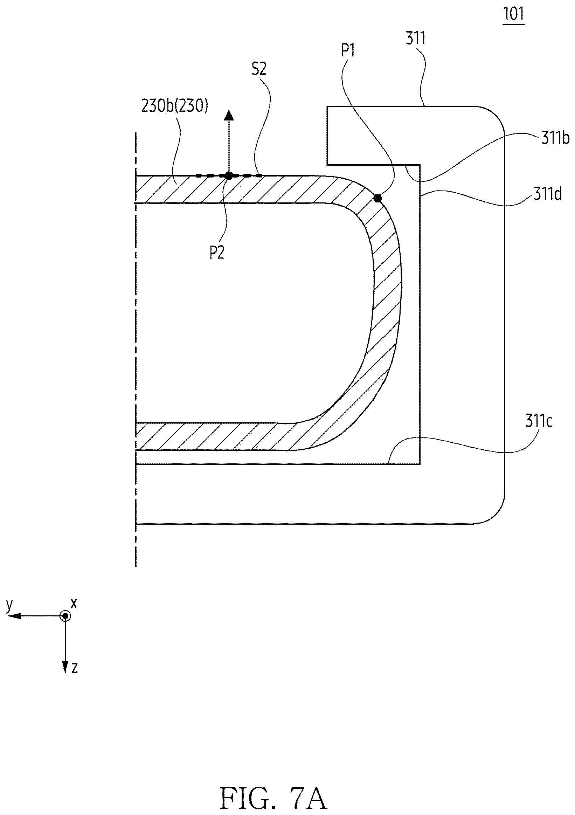

FIG. 7A is a cross-sectional view illustrating an example of cutting an exemplary electronic device according to an embodiment.

Referring to FIG. 7A, according to an embodiment, a second region 230b may have a substantially asymmetrical shape. A radius of curvature at a point of the second region 230b corresponding to a point in which a first inner surface 311b and an inner lateral surface 311d are in contact may be different from a radius of curvature at another point of the second region 230b corresponding to a point in which a second inner surface 311c and the inner lateral surface 311d are in contact. For example, the radius of curvature at the point of the second region 230b corresponding to the point in which the first inner surface 311b and the inner lateral surface 311d are in contact may be smaller than the radius of curvature at the other point of the second region 230b corresponding to the point in which the second inner surface 311c and the inner lateral surface 311d are in contact.

A first position p1 having a minimum radius of curvature in the second region 230b according to an embodiment may be close to the first inner surface 311b among the first inner surface 311b and the second inner surface 311c. For example, the first position p1 having the minimum radius of curvature in the second region 230b may be close to the point in which the first inner surface 311b and the inner lateral surface 311d are in contact among the point in which the first inner surface 311b and the inner lateral surface 311d are in contact and the point in which the second inner surface 311c and the inner lateral surface 311d are in contact. For example, a direction toward which a virtual surface s2 in contact with a second position p2 faces may be substantially the same as a direction (e.g., a -z direction) toward which a first region (e.g., the first region 230a of FIG. 5A) faces. The second position p2 may be close to the first inner surface 311b among the first inner surface 311b and the second inner surface 311c.

According to an embodiment, the inner lateral surface 311d may be substantially perpendicular to the first region 230a. For example, a direction (e.g., a +y direction) toward which the inner lateral surface 311d faces may be perpendicular to a direction (e.g., the -z direction) toward which the first region 230a faces. For example, the inner lateral surface 311d may be perpendicular to at least one of the first inner surface 311b and the second inner surface 311c.

As described above, since the first position p1 having minimum curvature in the second region 230b is disposed adjacent to the first inner surface 311b of a first cover 311, an electronic device 101 according to an embodiment may provide a structure in which an area of a display 230 visible from an outside of the electronic device 101 is maximized.

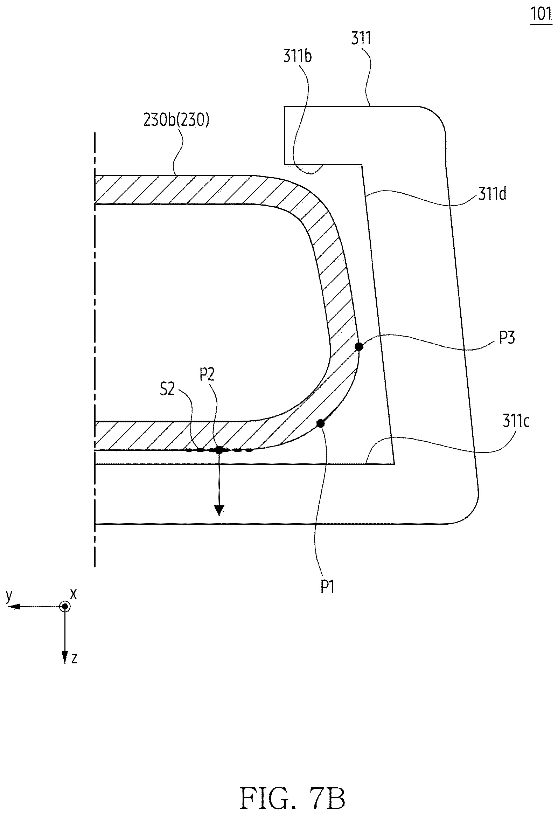

FIG. 7B is a cross-sectional view illustrating an example of cutting an exemplary electronic device according to an embodiment.

Referring to FIG. 7B, according to an embodiment, the second region 230b may have a substantially asymmetrical shape. The radius of curvature at the point of the second region 230b corresponding to the point in which the first inner surface 311b and the inner lateral surface 311d are in contact may be different from the radius of curvature at the other point of the second region 230b corresponding to the point in which the second inner surface 311c and the inner lateral surface 311d are in contact. For example, the radius of curvature at the point of the second region 230b corresponding to the point in which the first inner surface 311b and the inner lateral surface 311d are in contact may be greater than the radius of curvature at the other point of the second region 230b corresponding to the point in which the second inner surface 311c and the inner lateral surface 311d are in contact.

The first position p1 having the minimum radius of curvature in the second region 230b according to an embodiment may be close to the second inner surface 311c among the first inner surface 311b and the second inner surface 311c. For example, the first position p1 having the minimum radius of curvature in the second region 230b may be close to the point in which the second inner surface 311c and the inner lateral surface 311d are in contact among the point in which the first inner surface 311b and the inner lateral surface 311d are in contact and the point in which the second inner surface 311c and the inner lateral surface 311d are in contact. For example, the direction toward which the virtual surface s2 in contact with the second position p2 faces may be opposite to the direction (e.g., the -z direction) toward which the first region (e.g., the first region 230a of FIG. 5A) faces. The second position p2 may be close to the second inner surface 311c among the first inner surface 311b and the second inner surface 311c. As the second position p2 is adjacent to the second inner surface 311c, the first position p1 disposed between the second position p2 and a third position p3 may be adjacent to the second inner surface 311c.

According to an embodiment, the inner lateral surface 311d of the first cover 311 may be inclined with respect to at least one of the first inner surface 311b and the second inner surface 311c. For example, the inner lateral surface 311d of the first cover 311 may be inclined with respect to the first inner surface 311b. For example, the inner lateral surface 311d of the first cover 311 may be inclined with respect to the second inner surface 311b. For example, a direction toward which the inner lateral surface 311d of the first cover 311 faces may be inclined with respect to the direction toward which the first region 230a faces.

As described above, since the first position p1 having the minimum curvature in the second region 230b is disposed adjacent to the second inner surface 311c of the first cover 311, the electronic device 101 according to an embodiment may provide the structure in which the area of the display 230 visible from the outside of the electronic device 101 is maximized.

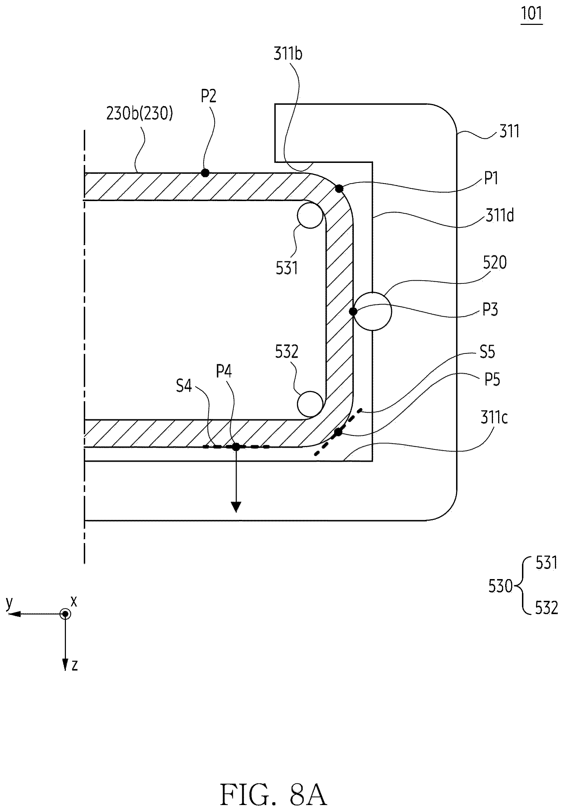

FIGS. 8A to 8D are cross-sectional views illustrating an example of cutting an exemplary electronic device according to an embodiment.

Referring to FIGS. 8A to 8D, a first position p1 having a minimum radius of curvature in a second region 230b may be adjacent to a first inner surface 311b among the first inner surface 311b and a second inner surface 311c. For example, a direction toward which a virtual surface s2 in contact with a second position p2 faces may correspond to a direction (e.g., a -z direction) toward which a first region (e.g., the first region 230a of FIG. 5A) faces. The second position p2 may be close to the first inner surface 311b among the first inner surface 311b and the second inner surface 311c. As the second position p2 is close to the first inner surface 311b, the first position p1 located between the second position p2 and a third position p3 may be close to the first inner surface 311b.

According to an embodiment, the second region 230b may include a fourth position p4 in which a direction (e.g., a +z direction) toward which a virtual surface s4 in contact with the second region 230b faces is opposite to a direction (e.g., the -z direction) toward which the first region 230a faces. For example, the fourth position p4 of the second region 230b may be close to the second inner surface 311c among the first inner surface 311b and the second inner surface 311c of a first cover 311. The fourth position p4 of the second region 230b may be distinguished from the second position p2 of the second region 230b. For example, the fourth position p4 of the second region 230b may be spaced apart from the second position p2 of the second region 230b.

According to an embodiment, the second region 230b may include a fifth position p5 having a radius of curvature corresponding to a radius of curvature of the first position p1. For example, the fifth position p5 may have substantially the same radius of curvature as the radius of curvature of the first position p1. According to an embodiment, the fifth position p5 may be disposed between the third position p3 and the fourth position p4. For example, the fifth position p5 may be distinguished from the third position p3 and the fourth position p4. For example, the fifth position p5 may be spaced apart from the third position p3 and the fourth position p4. According to an embodiment, a direction toward which a virtual surface s5 in contact with the fifth position p5 faces may be inclined with respect to a direction toward which the virtual surface s4 in contact with the fourth position p4 faces. For example, the direction toward which the virtual surface s5 in contact with the fifth position p5 faces may be inclined in a reference angle range with respect to the direction toward which the virtual surface s4 in contact with the fourth position p4 faces. For example, an angle between the direction toward which the virtual surface s5 in contact with the fifth position p5 faces and the direction toward which the virtual surface s4 in contact with the fourth position p4 faces may be about 30 degrees to about 60 degrees. For example, the angle between the direction toward which the virtual surface s5 in contact with the fifth position p5 faces and the direction toward which the virtual surface s4 in contact with the fourth position p4 faces may be about 45 degrees.

According to an embodiment, the first cover 311 may include at least one second supporting member 530. The at least one second supporting member 530 may support the second region 230b. According to an embodiment, the at least one second supporting member 530 may support an inner surface of the second region 230b opposite to an outer surface of the second region 230b facing the first cover 311. For example, the at least one second supporting member 530 may be disposed on the inner surface of the second region 230b. For example, the at least one second supporting member 530 may contact the inner surface of the second region 230b. According to an embodiment, the at least one second supporting member 530 may be disposed in the first cover 311. For example, the at least one second supporting member 530 may be coupled to the first cover 311 to be rotatable with respect to the first cover 311. For example, the at least one second supporting member 530 may be fastened in the first cover 311 as the at least one second supporting member 530 is coupled to the first cover 311. According to an embodiment, the at least one second supporting member 530 may define a minimum radius of curvature of the second region 230b. For example, the at least one second supporting member 530 may form a line-contact with the second region 230b. The minimum radius of curvature of the second region 230b may correspond to a radius of the at least one second supporting member 530. For example, the at least one second supporting member 530 may have a shape bent to have curvature. According to an embodiment, the at least one supporting member 530 may include a first roller 531, and a second roller 532.

The first roller 531 may be disposed between the second position p2 and the third position p3. For example, the first roller 531 may be in contact with a portion of the second region 230b including the first position p1. According to an embodiment, the first roller 531 may be rotatable with respect to the second region 230b. For example, the first roller 531 may contact the inner surface of the second region 230b and may be rotatable by movement of the second region 230b.

The second roller 532 may be disposed between the fourth position p4 and the third position p3. For example, the second roller 532 may contact another portion of the second region 230b including the fifth position p5. According to an embodiment, the second roller 532 may be rotatable with respect to the second region 230b. For example, the second roller 532 may contact the inner surface of the second region 230b and may be rotatable by the movement of the second region 230b.

According to an embodiment, the second region 230b may include a material capable of protecting the second region 230b facing the first cover 311. For example, the second region 230b may include a protective material (not illustrated) applied on the outer surface of the second region 230b. For example, the protective material may include a selfhealing material that may automatically repair damage. For example, the protective material may include a coating material for reinforcing rigidity of the outer surface of the second region 230b. The coating material may include, for example, at least one of a siloxane hybrid and acrylate, but it is not limited thereto.

Referring to FIG. 8A, according to an embodiment, a first supporting member 520 may be spaced apart from the at least one second supporting member 530. For example, the first supporting member 520 may be disposed between the first roller 531 and the second roller 532. According to an embodiment, the first supporting member 520 may support the outer surface of the second region 230b facing the first cover 311.

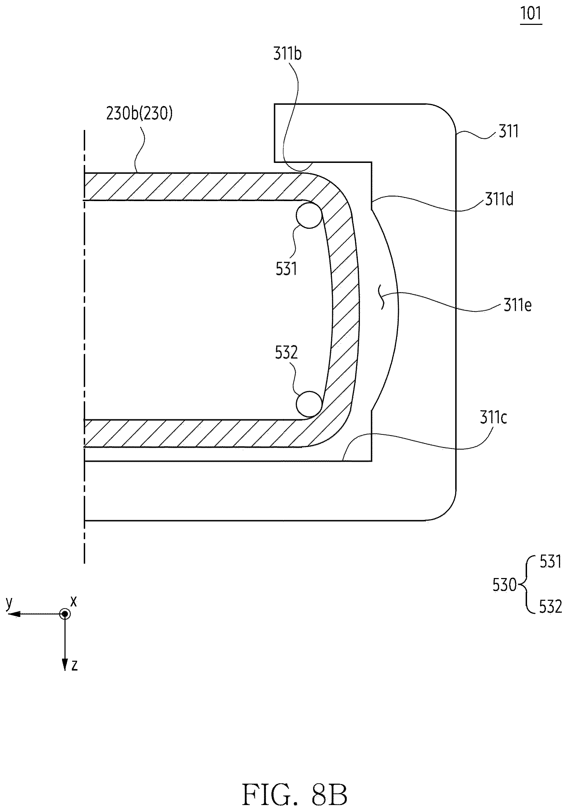

Referring to FIG. 8B, according to an embodiment, the first cover 311 may include a receiving groove 311e. As the receiving groove 311e separates the second region 230b from the first cover 311, the contact between the second region 230b and the first cover 311 may be reduced. The receiving groove 311e may be disposed on an inner lateral surface 311d of the first cover 311. For example, the receiving groove 311e may be formed by recessing at least a portion of the inner lateral surface 311d of the first cover 311. According to an embodiment, a size of the receiving groove 311e may correspond to a size of the inner lateral surface 311d of the first cover 311. For example, a height of the receiving groove 311e may correspond to a height of the inner lateral surface 311d of the first cover 311, but it is not limited thereto. For example, the height of the receiving groove 311e may be smaller than the height of the inner lateral surface 311d of the first cover 311.

According to an embodiment, the receiving groove 311e may face the outer surface of the second region 230b. The receiving groove 311e may have a shape corresponding to a shape of the second region 230b facing the inner lateral surface 311d of the first cover 311. For example, the receiving groove 311e may be bent to have curvature.

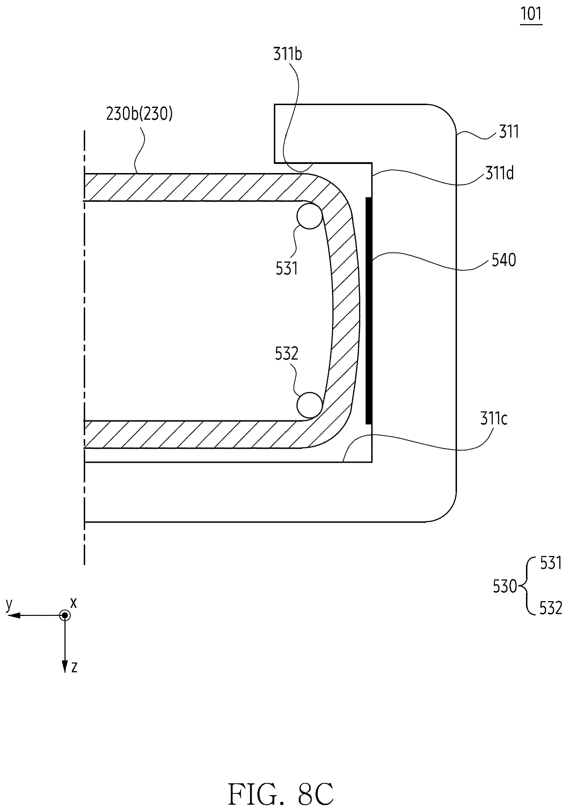

Referring to FIG. 8C, the first cover 311 may include a protecting member 540. The protecting member 540 may reduce damage to the second region 230b by contact with the first cover 311. For example, the protecting member 540 may have a form of a tape including an adhesive material. For example, the protecting member 540 may include Teflon, but it is not limited thereto. According to an embodiment, as the protecting member 540 is disposed on the first cover 311, the protecting member 540 may face the second area 230b. For example, the protecting member 540 may be disposed on the inner lateral surface 311d of the first cover 311. For example, the protecting member 540 may be attached on the inner lateral surface 311d. According to an embodiment, a size of the protecting member 540 may correspond to the size of the inner lateral surface 311d of the first cover 311. For example, a height of the protecting member 540 may correspond to the height of the inner lateral surface 311d of the first cover 311, but it is not limited thereto. For example, the height of the protecting member 540 may be smaller than the height of the inner lateral surface 311d of the first cover 311. According to an embodiment, the protecting member 540 may be substantially parallel to the inner lateral surface 311d of the first cover 311.

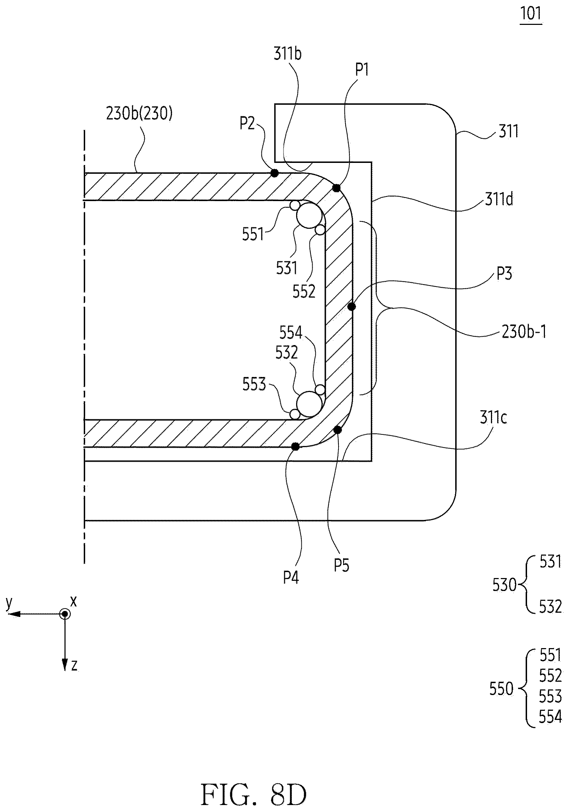

Referring to FIG. 8D, according to an embodiment, the first cover 311 may include at least one contact member 550. The at least one contact member 550 may alleviate curvature of the second region 230b. For example, the at least one contact member 550 may include a first contact member 551, a second contact member 552, a third contact member 553, and/or a fourth contact member 554.

The first contact member 551 may be disposed adjacent to the first position p1. For example, the first contact member 551 may contact the first roller 531 in contact with a portion of the second region 230b including the first position p1. The second contact member 552 may be spaced apart from the first contact member 551. For example, the second contact member 552 may contact the first roller 531. According to an embodiment, the first contact member 551 and the second contact member 552 may surround the first roller 531. For example, the first roller 531 may be disposed between the first contact member 551 and the second contact member 552. According to one embodiment, the second contact member 552 may contact a region 230b-1 of the second region 230b including the third position p3.

The third contact member 553 may be disposed adjacent to the fifth position p5. For example, the third contact member 553 may contact a portion of the second region 230b including the fifth position p5. The fourth contact member 554 may be spaced apart from the third contact member 553. According to an embodiment, the third contact member 553 and the fourth contact member 554 may surround the second roller 532. For example, the second roller 532 may be disposed between the third contact member 553 and the fourth contact member 554. According to an embodiment, the fourth contact member 554 may contact the region 230b-1 of the second region 230b including the third position p3. For example, the fourth contact member 554 may be spaced apart from the second contact member 552.

For example, in case that the at least one contact member 550 is omitted, the curvature of the second region 230b may be rapidly changed between the second position p2 and the third position p3 and/or between the third position p3 and the fourth position p4. In case that the curvature of the second region 230b is rapidly changed, the second region 230b may be damaged by stress generated within the second region 230b. An electronic device 101 according to an embodiment may provide a structure capable of gradually changing the curvature of the second region 230b by a plurality of contact members 551, 552, 553, and 554 supporting a portion of the second region 230b adjacent to the first roller 531 and the second roller 532, respectively. The electronic device 101 according to an embodiment may provide a structure capable of reducing damage to the second region 230b as the curvature of the second region 230b is gradually changed.

As described above, the electronic device 101 according to an embodiment may provide a structure in which the first position p1 having the minimum radius of curvature in the second region 230b is spaced apart from the second position p2 and the third position p3 by the at least one second supporting member 530 supporting the second region 230b.

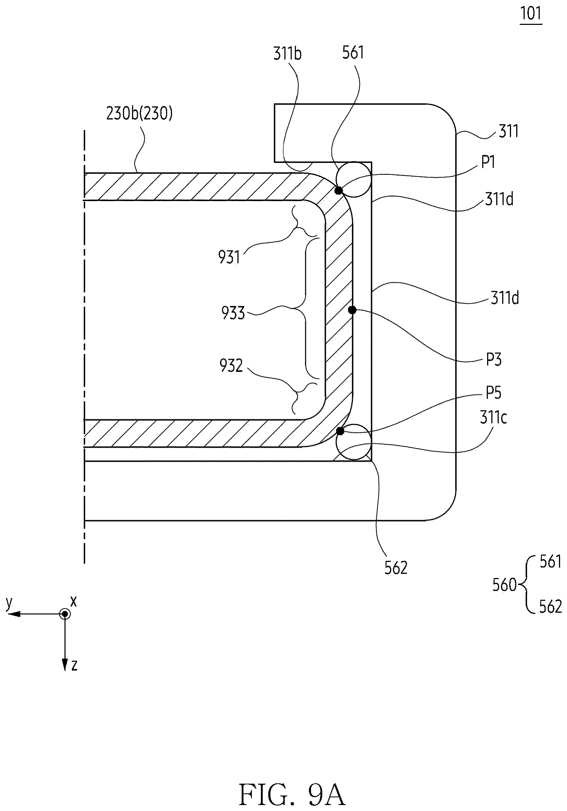

FIGS. 9A to 9C are cross-sectional views illustrating an example of cutting an exemplary electronic device according to an embodiment.

Referring to FIGS. 9A to 9C, according to an embodiment, a second region 230b may include a first extension portion 931, a second extension portion 932, and/or a third extension portion 933. According to an embodiment, the first extension portion 931, the second extension portion 932, and/or the third extension portion 933 may each mean a portion of the second region 230b disposed within a first cover 311 in a first state of an electronic device 101.

The first extension portion 931 may have curvature and may be bent. For example, the first extension portion 931 may have curvature as the first extension portion 931 is bent with respect to a first inner surface 311b. According to an embodiment, the first extension portion 931 may face the first inner surface 311b and an inner lateral surface 311d. For example, the first extension portion 931 may be close to the first inner surface 311b among the first inner surface 311b and a second inner surface 311c. According to an embodiment, a first position p1 having minimum curvature in the second region 230b may be defined in the first extension portion 931. For example, the first position p1 may be included within the first extension portion 931. For example, the first position p1 may be located within the first extension portion 931.

The second extension portion 932 may have curvature and may be bent. For example, the second extension portion 932 may have the curvature as the second extension portion 932 is bent with respect to the second inner surface 311c. The second extension portion 932 may be spaced apart from the first extension portion 931. According to an embodiment, the second extension portion 932 may face the second inner surface 311c and the inner lateral surface 311d. For example, the second extension portion 932 may be close to the second inner surface 311c among the first inner surface 311b and the second inner surface 311c. According to an embodiment, a fifth position p5 in the second region 230b having a radius of curvature corresponding to a radius of curvature of the first position p1 may be defined in the second extension portion 932. For example, the fifth position p5 may be included within the second extension portion 932. For example, the fifth position p5 may be located within the second extension portion 932.

The third extension portion 933 may connect the first extension portion 931 and the second extension portion 932. For example, the third extension portion 933 may be substantially perpendicular to the first inner surface 311b. For example, the third extension portion 933 may not have curvature. For example, the third extension portion 933 may be substantially parallel to the inner lateral surface 311d. For example, the third extension portion 933 may be substantially perpendicular to the second inner surface 311c. According to an embodiment, a third position p3 in which a direction toward which a virtual surface in contact with the second region 230b faces is perpendicular to a first region (e.g., the first region 230a of FIG. 5A) may be defined in the third extension portion 933. For example, the third position p3 may be included within the third extension portion 933. For example, the third position p3 may be located within the third extension portion 933.

According to an embodiment, the first cover 311 may include at least one third supporting member 560. The at least one third supporting member 560 may support the second region 230b. For example, the second region 230b supported by the at least one third supporting member 560 may have curvature. According to an embodiment, the at least one third supporting member 560 may face an outer surface of the second region 230b facing the first cover 311. For example, the at least one third supporting member 560 may contact the outer surface of the second region 230b. According to an embodiment, the at least one third supporting member 560 may be disposed in the first cover 311. For example, the at least one third supporting member 560 may be coupled to the first cover 311 to be rotatable with respect to the first cover 311, but it is not limited thereto. For example, the at least one third supporting member 560 may be fastened in the first cover 311.

Referring to FIG. 9A, according to an embodiment, the at least one third supporting member 560 may include a third roller 561 and a fourth roller 562. The third roller 561 may be disposed between the first inner surface 311b and the inner lateral surface 311d of the first cover 311. For example, the third roller 561 may face the first inner surface 311b and the inner lateral surface 311d. For example, a position of the third roller 561 may correspond to a position in which the first inner surface 311b is in contact with the inner lateral surface 311d. According to an embodiment, the third roller 561 may contact the first extension portion 931. The third roller 561 may define the first position p1 having the minimum curvature in the second region 230b. For example, the first position p1 may be defined in the first extension portion 931 of the second region 230b in contact with the third roller 561. For example, a position in which the third roller 561 is in contact with the second region 230b may be substantially the same as the first position p1.

The fourth roller 562 may be disposed between the second inner surface 311c and the inner lateral surface 311d. For example, the fourth roller 562 may face the second inner surface 311c and the inner lateral surface 311d. For example, a position of the fourth roller 562 may correspond to a position in which the second inner surface 311c is in contact with the inner lateral surface 311d. According to an embodiment, the fourth roller 562 may contact the second extension portion 932. The fourth roller 562 may define the fifth position p5 of the second region 230b having a radius of curvature corresponding to the radius of curvature of the first position p1. For example, the fifth position p5 may be defined in the second extension portion 932 of the second region 230b in contact with the fourth roller 562. For example, a position in which the fourth roller 562 is in contact with the second region 230b may be substantially the same as the fifth position p5.

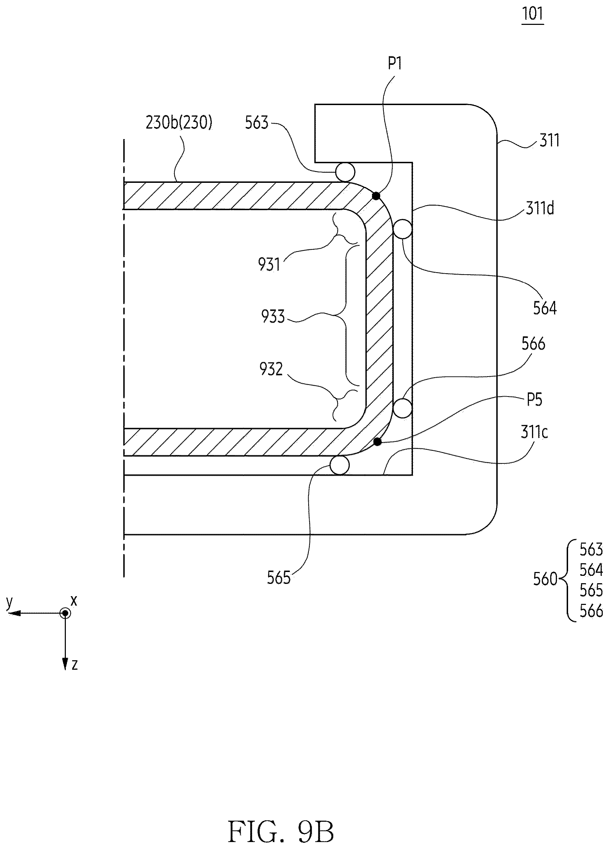

Referring to FIG. 9B, according to an embodiment, the at least one third supporting member 560 may include a fifth roller 563, a sixth roller 564, a seventh roller 565, and/or an eighth roller 566. The fifth roller 563 may be disposed on the first inner surface 311b. According to an embodiment, the fifth roller 563 may contact the outer surface of the second region 230b. For example, the fifth roller 563 may contact the first extension portion 931 of the second region 230b. The sixth roller 564 may be disposed on the inner lateral surface 311d of the first cover 311. The sixth roller 564 may be spaced apart from the fifth roller 563. According to an embodiment, the sixth roller 564 may contact the outer surface of the second region 230b. For example, the sixth roller 564 may contact the first extension portion 931 of the second region 230b. According to an embodiment, the first position p1 having the minimum curvature in the second region 230b may be defined between the fifth roller 563 and the sixth roller 564. For example, the first position p1 may be located in the first extension portion 931 between the fifth roller 563 and the sixth roller 564.

The seventh roller 565 may be disposed on the second inner surface 311c of the first cover 311. According to an embodiment, the seventh roller 565 may contact the outer surface of the second region 230b. For example, the seventh roller 565 may contact the second extension portion 932 of the second region 230b. The eighth roller 566 may be disposed on the inner lateral surface 311d of the first cover 311. The eighth roller 566 may be spaced apart from the seventh roller 565. The eighth roller 566 may be spaced apart from the sixth roller 564 on the inner lateral surface 311d of the first cover 311. For example, the eighth roller 566 may be spaced apart from the sixth roller 564 in a direction (e.g., a -z direction) toward which the first inner surface 311b faces. According to an embodiment, the fifth position p5 in the second region 230b having the radius of curvature corresponding to the radius of curvature of the first position p1 may be defined between the seventh roller 565 and the eighth roller 566. For example, the fifth position p5 may be located in the second extension portion 932 between the seventh roller 565 and the eighth roller 566.

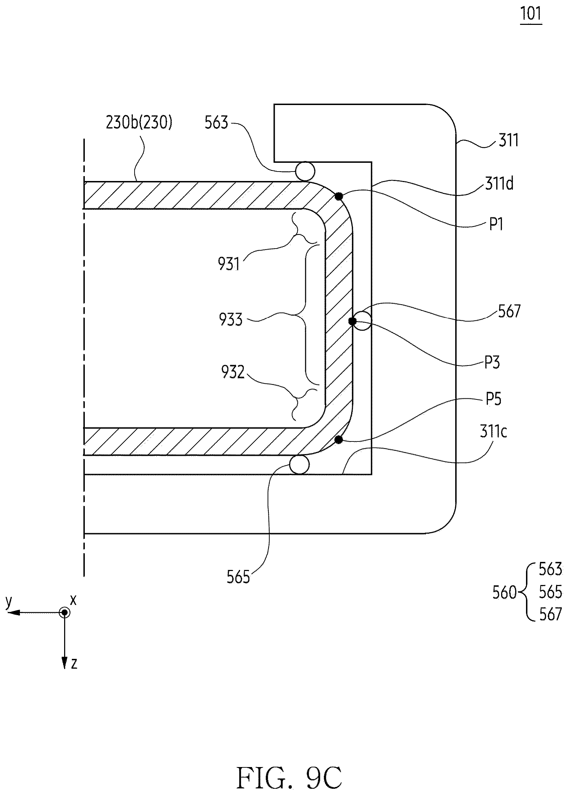

Referring to FIG. 9C, the at least one third supporting member 560 may include a ninth roller 567. The ninth roller 567 may be spaced apart from the fifth roller 563 disposed on the first inner surface 311b. The ninth roller 567 may be spaced apart from the seventh roller 565 disposed on the second inner surface 311c. According to an embodiment, the ninth roller 567 may contact the outer surface of the second region 230b. For example, the ninth roller 567 may contact the third extension portion 933 of the second region 230b. According to an embodiment, the ninth roller 567 may contact the third position p3 of the second region 230b. The first position p1 of the second region 230b may be defined between the fifth roller 563 and the ninth roller 567. The fifth position p5 of the second region 230b may be defined between the seventh roller 565 and the ninth roller 567.

As described above, the electronic device 101 according to an embodiment may provide a structure in which the first position p1, the second position p2, and the third position p3 are spaced apart by the at least one third supporting member 560 supporting the second region 230b.

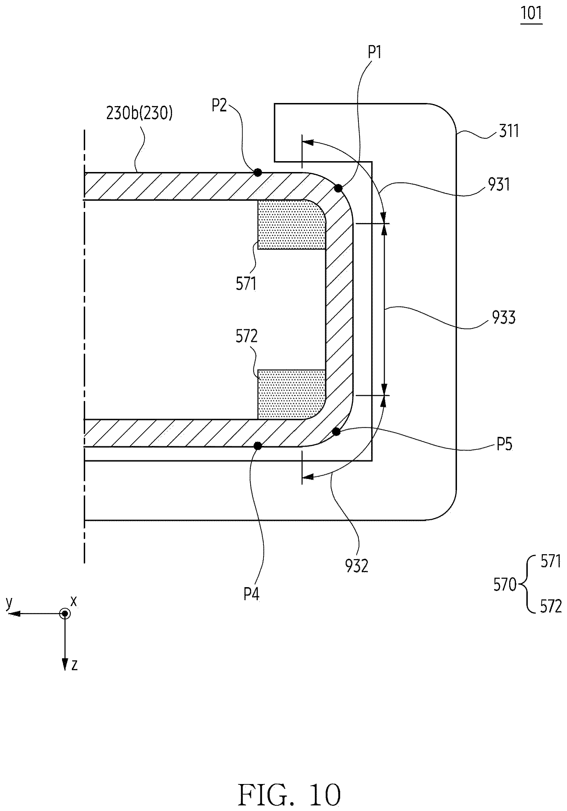

FIG. 10 is a cross-sectional view illustrating an example of cutting an exemplary electronic device according to an embodiment.

Referring to FIG. 10, a first cover 311 may include at least one fourth supporting member 570. The at least one fourth supporting member 570 may be disposed on an inner surface of a second region 230b opposite to an outer surface of the second region 230b facing the first cover 311. The at least one fourth supporting member 570 may contact the inner surface of the second region 230b. According to an embodiment, the at least one fourth supporting member 570 may be disposed in the first cover 311. For example, the at least one fourth supporting member 570 may be fastened in the first cover 311. According to an embodiment, the at least one fourth supporting member 570 may form a surface-contact with the second region 230b. As the surface-contact of the at least one fourth supporting member 570 and the second region 230b is formed, a change in curvature of the second region 230b in the first cover 311 may become gradual. As the change in the curvature of the second region 230b becomes gradual, damage to the second region 230b may be reduced. For example, the at least one fourth supporting member 570 may include a first supporting portion 571 and a second supporting portion 572.

The first supporting portion 571 may contact a portion of a first extension portion 931 and a third extension portion 933 of the second region 230b. The first supporting portion 571 may contact a portion of the second region 230b including a first position p1 having minimum curvature and the second position p2 of the second region 230b. For example, the first supporting portion 571 may contact a portion of the second region 230b, including the first position p1, the second position p2, and a third position p3 of the second region 230b.

The second supporting portion 572 may contact another portion of the second extension portion 932 and the third extension portion 933 of the second region 230b. The second supporting portion 572 may contact another portion of the second region 230b including a fourth position p4 and a fifth position p5. For example, the second supporting portion 572 may contact the other portion of the second region 230b including the fourth position p4, the fifth position p5, and the third position p3.

As described above, an electronic device 101 according to an embodiment may provide a structure capable of reducing a rapid change in curvature within the second region 230b by the at least one fourth supporting member 570 forming the surface-contact with the second region 230b.

A display of an electronic device may be slidable with respect to a cover surrounding the display. In order to expand the display, a portion of the display may be bent to have curvature within the cover. In case that an area of the display covered by the cover is increased, an area of the display visible from an outside of the electronic device may be reduced. The electronic device may need a structure capable of supporting the display within the cover in order to expand the area of the display visible from the outside.

An electronic device (e.g., the electronic device 101 of FIGS. 5A and 5B) according to an embodiment may comprise a first cover (e.g., the first cover 311 of FIGS. 5A and 5B). According to an embodiment, the electronic device may comprise a second cover (e.g., the second cover 321 of FIG. 5A) slidable in a first direction or a second direction opposite to the first direction with respect to the first cover. According to an embodiment, the electronic device may comprise a display (e.g., the display 230 of FIGS. 5A and 5B) including a first region (e.g., the first region 230a of FIG. 5A) that is always exposed to an outside of the first cover and a second region (e.g., the second region 230b of FIG. 5A) extending from the first region, wherein the second region is exposed to the outside of the first cover as the second cover moves in the first direction or is rolled to have curvature that changes in the first cover as the second cover moves in the second direction. According to an embodiment, a first position (e.g., the first position p1 of FIG. 5B) having a minimum radius of curvature (e.g., the minimum radius of curvature r1 of FIG. 5B) in the second region may be located between a second position (e.g., the second position p2 of FIG. 5B) of the second region in which a direction toward which a virtual surface (e.g., the virtual surface s2 of FIG. 5B) that contacts the second region bent to have curvature in the first cover faces corresponds to a direction toward which the first region faces and a third position (e.g., the third position p3 of FIG. 5B) of the second region in which a direction toward which the virtual surface (e.g., the virtual surface s3 of FIG. 5B) faces is perpendicular to the direction toward which the first region faces. According to an embodiment, a direction toward which the virtual surface (e.g., the virtual surface s1 of FIG. 5B) that contacts the first position faces may be inclined with respect to the direction toward which the first region faces, within a reference angle range.

The electronic device according to an embodiment may provide a structure that reduces an area of the display covered by the first cover since the first position in which the direction toward which the virtual surface faces is inclined with respect to the direction toward which the first region faces is spaced apart from the second position and the third position of the second region.

According to an embodiment, the minimum radius of curvature of the second region may be smaller than half a height of an inner lateral surface (e.g., the inner lateral surface 311d of FIG. 5B) of the first cover perpendicular to the direction toward which the first region faces.

Since a minimum radius of curvature of the first position is smaller than half of the inner lateral surface of the first cover, the electronic device according to an embodiment may provide a structure that reduces an area of the display covered by the first cover.

According to an embodiment, the electronic device may comprise at least one guide bar (e.g., the guide bar 511 of FIGS. 5A and 5B), disposed on an inner surface of the second region from among the first region and the second region, guiding movement of the second region. According to an embodiment, the electronic device may comprise a guide rail (e.g., the guide rail 512 of FIGS. 5A and 5B), including a guiding groove (e.g., the guiding groove 512c of FIGS. 5A and 5B) that accommodates the at least one guide bar, disposed in the first cover, and surrounded by the display. According to an embodiment, the guiding groove may extend along the guide rail such that the first position is located on an edge of the rail.

The electronic device according to an embodiment may provide a structure in which the first position is distinguished from the second position and the third position by the at least one guide bar guiding movement of the display and the guide rail guiding movement of the at least one guide bar.

According to an embodiment, the first cover may include a first supporting member (e.g., the first supporting member 520 of FIG. 6), disposed on the inner lateral surface (e.g., the inner lateral surface 311d of FIG. 5B) of the first cover perpendicular to the direction toward which the first region faces, corresponding to the third position.

The electronic device according to an embodiment may provide a structure that reduces bending of the display close to the inner lateral surface of the first cover by the first supporting member corresponding to the third position.

According to an embodiment, the first supporting member may be rotatable with respect to the second region.

The electronic device according to an embodiment may provide a structure that reduces bending of the display close to the inner lateral surface of the first cover by the rotatable first supporting member.

According to an embodiment, the first cover may include at least one second supporting member (e.g., the second supporting member 530 of FIGS. 8A to 8D) supporting the inner surface of the second region opposite to an outer surface of the second region facing the first cover. According to an embodiment, the minimum radius of curvature of the second region may correspond to a radius of the at least one second supporting member.

The electronic device according to an embodiment may provide a structure that reduces an area of the display covered by the first cover by the at least one second supporting member corresponding to the minimum radius of curvature of the second region.

According to an embodiment, the at least one second supporting member may include a first roller (e.g., the first roller 531 of FIGS. 8A to 8D), disposed between the second position and the third position, rotatable with respect to the second region. According to an embodiment, the at least one second supporting member may include a second roller (e.g., the second roller 532 of FIGS. 8A to 8D), disposed between the third position and a fourth position of the second region in which a direction toward which the virtual surface that contacts the second region faces is opposite to the direction toward which the first region faces, rotatable with respect to the second region. According to an embodiment, a fifth position of the second region having a radius of curvature corresponding to a radius of curvature of the first position may be located between the third position and the fourth position.

The electronic device according to an embodiment may provide a structure that reduces an area of the display covered by the first cover by the first roller and the second roller of the at least one second supporting member.

According to an embodiment, the first cover may include a receiving groove (e.g., the receiving groove 311e of FIG. 8B) formed by recessing at least a portion of the inner lateral surface of the first cover perpendicular to the direction toward which the first region faces. According to an embodiment, the receiving groove may have a shape corresponding to the second region facing the inner lateral surface of the first cover.

The electronic device according to an embodiment may provide a structure that reduces contact between the second region and the first cover by the receiving groove of the first cover facing the second region.

According to an embodiment, the electronic device may comprise a third roller (e.g., the third roller 561 of FIG. 9A) disposed between a first inner surface of the first cover facing a direction opposite to the direction toward which the first region faces and the inner lateral surface of the first cover perpendicular to the direction toward which the first region faces. According to an embodiment, the first position may be defined within a portion of the second region that contacts the third roller.

The electronic device according to an embodiment may provide a structure that reduces an area of the display covered by the first cover by the third roller.

According to an embodiment, the electronic device may comprise a fourth roller (e.g., the fourth roller 562 of FIG. 9A) disposed between a second inner surface of the first cover facing the first inner surface, and the inner lateral surface. According to an embodiment, the position of the second region having the radius of curvature corresponding to the radius of curvature of the first position may be defined within another portion of the second region that contacts the fourth roller.

The electronic device according to an embodiment may provide a structure that reduces an area of the display covered by the first cover by the fourth roller.

According to an embodiment, the electronic device may comprise a fifth roller (e.g., the fifth roller 563 of FIG. 9B) disposed on the first inner surface of the first cover facing the direction opposite to the direction toward which the first region faces. According to an embodiment, the electronic device may comprise a sixth roller (e.g., the sixth roller 564 of FIG. 9B) disposed on the inner lateral surface of the first cover perpendicular to the direction toward which the first region faces. According to an embodiment, the first position may be defined between the fifth roller and the sixth roller.

The electronic device according to an embodiment may provide a structure that reduces an area of the display covered by the first cover by the fifth roller and the sixth roller.

According to an embodiment, the electronic device may comprise a seventh roller (e.g., the seventh roller 567 of FIG. 9B) disposed on the second inner surface of the first cover facing the first inner surface. According to an embodiment, the position of the second region having the radius of curvature corresponding to the radius of curvature of the first position may be defined between the sixth roller and the seventh roller.

The electronic device according to an embodiment may provide a structure that reduces an area of the display covered by the first cover by the seventh roller.

According to an embodiment, the electronic device may comprise the seventh roller disposed on the second inner surface of the first cover facing the first inner surface. According to an embodiment, the electronic device may comprise an eighth roller (e.g., the eighth roller 566 of FIG. 9B), disposed on the inner lateral surface of the first cover, spaced apart from the sixth roller. According to an embodiment, a position of the second region having the radius of curvature corresponding to the radius of curvature of the first position may be defined between the seventh roller and the eighth roller.

The electronic device according to an embodiment may provide a structure that reduces an area of the display covered by the first cover by the seventh roller and the eighth roller.

According to an embodiment, the first cover may include a protecting member (e.g., the protecting member 540 of FIG. 8C), disposed on the inner lateral surface of the first cover that is perpendicular to the direction toward which the first region faces, and facing the second region.

The electronic device according to an embodiment may provide a structure capable of reducing damage to the display by the protecting member facing the second region.

According to an embodiment, the first cover may include the first inner surface (e.g., the first inner surface 311b of FIG. 5B) facing the direction opposite to the direction toward which the first region faces. According to an embodiment, the first cover may include the second inner surface (e.g., the second inner surface 311c of FIG. 5B), facing the first inner surface, spaced apart from the first inner surface. According to an embodiment, the first position may be close to the first inner surface from among the first inner surface and the second inner surface.

The electronic device according to an embodiment may provide a structure capable of reducing an area of the display covered by the first cover since the first position having the minimum radius of curvature is located close to the first inner surface.

An electronic device (e.g., the electronic device 101 of FIGS. 5A and 5B) according to an embodiment may comprise a first cover (e.g., the first cover 311 of FIGS. 5A and 5B). According to an embodiment, the electronic device may comprise a second cover (e.g., the second cover 321 of FIG. 5A), at least partially surrounded by the first cover, slidable with respect to the first cover in a first direction or a second direction opposite the first direction. According to an embodiment, the electronic device may comprise a display (e.g., the display 230 of FIGS. 5A and 5B) including a first region (e.g., the first region 230a of FIG. 5A) in contact with a surface of the second cover and a second region (e.g., the second region 230b of FIG. 5A) extending from the first region, wherein the second region is exposed to an outside of the second cover as the second cover moves in the first direction or covered by the first cover as the second cover moves in the second direction. According to an embodiment, a first position (e.g., the first position p1 of FIG. 5B) having a minimum radius of curvature (e.g., the minimum radius of curvature r1 of FIG. 5B) in the second region may be located between a second position (e.g., the second position p2 of FIG. 5B) of the second region in which a direction toward which a virtual surface (e.g., the virtual surface s2 of FIG. 5B) that contacts the second region bent to have curvature in the first cover faces corresponds to a direction toward which the first region faces and a third position (e.g., the third position p3 of FIG. 5B) of the second region in which a direction toward which the virtual surface (e.g., the virtual surface s3 of FIG. 5B) faces is perpendicular to the direction toward which the first region faces. According to an embodiment, a direction toward which the virtual surface (e.g., virtual surface s1 of FIG. 5B) that contacts the first position faces may be inclined with respect to the direction toward which the first region faces within a reference angle range. According to an embodiment, the minimum radius of curvature may less than half a height of an inner lateral surface (e.g., the inner lateral surface 311d of FIG. 5B) of the first cover perpendicular to the direction toward which the first region faces.

The electronic device according to an embodiment may provide a structure that reduces an area of the display covered by the first cover since the first position in which the direction toward which the virtual surface faces is inclined with respect to the direction toward which the first region faces is spaced apart from the second position and the third position of the second region.

According to an embodiment, the electronic device may comprise at least one guide bar (e.g., the guide bar 511 of FIGS. 5A and 5B), disposed on an inner surface of the second region from among the first region and the second region, guiding movement of the second region. According to an embodiment, the electronic device may comprise a guide rail (e.g., the guide rail 512 of FIGS. 5A and 5B), including a guiding groove (e.g., the guiding groove 512c of FIGS. 5A and 5B) that accommodates the at least one guide bar, disposed in the first cover, and surrounded by the display. According to an embodiment, the guiding groove may extend along the guide rail such that the first position is located on an edge of the rail.

The electronic device according to an embodiment may provide a structure in which the first position is distinguished from the second position and the third position by the at least one guide bar guiding the movement of the display and the guide rail guiding the movement of the at least one guide bar.

According to an embodiment, the first cover may include a first supporting member (e.g., the first supporting member 520 of FIG. 6), disposed on the inner lateral surface (e.g., the inner lateral surface 311d of FIG. 5B) of the first cover perpendicular to the direction toward which the first region faces, corresponding to the third position.

The electronic device according to an embodiment may provide a structure that reduces bending of the display close to the inner lateral surface of the first cover by the first supporting member corresponding to the third position.

According to one embodiment, the first cover may include at least one second supporting member (e.g., the second supporting member 530 of FIGS. 8A to 8D) supporting an inner surface of the second region opposite to an outer surface of the second region facing the first cover. According to an embodiment, the minimum radius of curvature of the second region may correspond to a radius of the at least one second supporting member.

The electronic device according to an embodiment may provide a structure that reduces an area of the display covered by the first cover by the at least one second supporting member corresponding to the minimum radius of curvature of the second region.

According to an embodiment, the first cover may include a receiving groove (e.g., the receiving groove 311e of FIG. 8B) formed by recessing at least a portion of the inner lateral surface of the first cover perpendicular to the direction toward which the first region faces. According to an embodiment, the receiving groove may have a shape corresponding to a shape of the second region facing the inner lateral surface of the first cover.

The electronic device according to an embodiment may provide a structure that reduces contact between the second region and the first cover by the receiving groove of the first cover facing the second region.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a first cover (311);
a second cover (321) movable in a first direction (261) or a second direction (262) opposite to the first direction (261) with respect to the first cover (311); and
a display (230) including a first region (230a) that is exposed to an outside of the first cover (311) independently of movement of the second cover (321) in the first direction (261) and movement of the second cover (321) in the second direction (262) and
a second region (230b) extending from the first region (230a), wherein the second region (230b) is exposed to the outside of the first cover (311) as the second cover (321) moves in the first direction (261) or is rolled into an inside of the first cover (311) as the second cover (321) moves in the second direction (262), and
wherein a first position (p1) having a minimum radius of curvature in the second region (230b) is located between:
a second position (p2) of the second region (230b) in which a direction toward which a virtual surface (s2) that contacts the second region (230b) bent to have curvature in the first cover (311) faces corresponds to a direction toward which the first region (230a) faces; and
a third position (p3) of the second region (230b) in which a direction toward which a virtual surface (s3) faces is perpendicular to the direction toward which the first region (230a) faces, and
wherein a direction toward which a virtual surface (s1) that contacts the first position (p1) faces is inclined with respect to the direction toward which the first region (230a) faces, within a reference angle range.

2. The electronic device of claim 1,
wherein the minimum radius of curvature of the second region (230b) is smaller than half a height of an inner lateral surface (311d) of the first cover (311) perpendicular to the direction toward which the first region (230a) faces.

3. The electronic device of any one of claim 1 and claim 2, further comprising:
at least one guide bar (511), disposed on an inner surface of the second region (230b) from among the first region (230a) and the second region (230b), guiding movement of the second region (230b); and
a guide rail (512), including a guiding groove (512c) that accommodates the at least one guide bar (511), disposed in the first cover (311), and surrounded by the display (230), and
wherein the guiding groove (512c) extends along the guide rail (512) such that the first position (p1) is located on an edge of the rail.

4. The electronic device of any one of claims 1 to 3,
wherein the first cover (311) includes:
a first supporting member (520), disposed on the inner lateral surface (311d) of the first cover (311) perpendicular to the direction toward which the first region (230a) faces, disposed on a position corresponding to the third position (p3).

5. The electronic device of any one of claims 1 to 4,
wherein the first supporting member (520) is rotatable with respect to the second region (230b).

6. The electronic device of any one of claims 1 to 5,
wherein the first cover (311) includes:
at least one second supporting member (530) supporting the inner surface of the second region (230b) opposite to an outer surface of the second region (230b) facing the first cover (311), and
wherein the minimum radius of the curvature of the second region (230b) corresponds to a radius of the at least one second supporting member (530).

7. The electronic device of any one of claims 1 to 6,
wherein the at least one second supporting member (530) includes:
a first roller (531), disposed between the second position (p2) and the third position (p3), rotatable with respect to the second region (230b); and
a second roller (532), disposed between the third position (p3) and a fourth position (p4) of the second region (230b) in which a direction toward which the virtual surface that contacts the second region (230b) faces is opposite to the direction toward which the first region (230a) faces, rotatable with respect to the second region (230b), and
wherein a fifth position (p5) of the second region (230b) having a radius of curvature corresponding to a radius of curvature of the first position (p1) is located between the third position (p3) and the fourth position (p4).

8. The electronic device of any one of claims 1 to 7,
wherein the first cover (311) includes:
a receiving groove (311e) formed by recessing at least a portion of the inner lateral surface (311d) of the first cover (311) perpendicular to the direction toward which the first region (230a) faces, and
wherein the receiving groove (311e) has a shape corresponding to the second region (230b) facing the inner lateral surface (311d) of the first cover (311).

9. The electronic device of any one of claims 1 to 8, further comprising:
a third roller (561) disposed between a first inner surface (311b) of the first cover (311) facing a direction opposite to the direction toward which the first region (230a) faces and the inner lateral surface (311d) of the first cover (311) perpendicular to the direction toward which the first region (230a) faces, and
wherein the first position (p1) is defined within a portion of the second region (230b) that contacts the third roller (561).

10. The electronic device of any one of claims 1 to 9, further comprising:
a fourth roller (562) disposed between a second inner surface (311c) of the first cover (311) facing the first inner surface (311b), and the inner lateral surface (311d), and
the position (p5) of the second region (230b) having the radius of curvature corresponding to the radius of curvature of the first position (p1) is defined within another portion of the second region (230b) that contacts the fourth roller (562).

11. The electronic device of any one of claims 1 to 10, further comprising:
a fifth roller (563) disposed on the first inner surface (311b) of the first cover (311) facing the direction opposite to the direction toward which the first region (230a) faces; and
a sixth roller (564) disposed on the inner lateral surface (311d) of the first cover (311) perpendicular to the direction toward which the first region (230a) faces, and
wherein the first position (p1) is defined between the fifth roller (563) and the sixth roller (564).

12. The electronic device of any one of claims 1 to 11, further comprising:
a seventh roller (565) disposed on the second inner surface (311c) of the first cover (311) facing the first inner surface (311b), and
wherein the position (p5) of the second region (230b) having the radius of curvature corresponding to the radius of curvature of the first position (p1) is defined between the sixth roller (564) and the seventh roller (565).

13. The electronic device of any one of claims 1 to 12, further comprising:
the seventh roller disposed on the second inner surface (311c) of the first cover (311) facing the first inner surface (311b); and
an eighth roller, disposed on the inner lateral surface (311d) of the first cover (311), spaced apart from the sixth roller (564), and
wherein a position of the second region (230b) having the radius of curvature corresponding to the radius of curvature of the first position (p1) is defined between the seventh roller and the eighth roller.

14. The electronic device of any one of claims 1 to 13,
wherein the first cover (311) includes:
a protecting member (540), disposed on the inner lateral surface (311d) of the first cover (311) that is perpendicular to the direction toward which the first region (230a) faces, and facing the second region (230b).

15. The electronic device of any one of claims 1 to 14,
wherein the first cover (311) includes:
the first inner surface (311b) facing the direction opposite to the direction toward which the first region (230a) faces; and
the second inner surface (311c), facing the first inner surface (311b), spaced apart from the first inner surface (311b), and
wherein the first position (p1) is closer to the first inner surface (311b) from among the first inner surface (311b) and the second inner surface (311c).
